(19) Europäisches Patentamt / European Patent Office / Office européen des brevets

(11) **EP 4 160 956 B1**

(12) **EUROPEAN PATENT SPECIFICATION**

(45) Date of publication and mention
of the grant of the patent:
**29.10.2025 Bulletin 2025/44**

(21) Application number: **21827032.0**

(22) Date of filing: **18.06.2021**

(51) International Patent Classification (IPC):
*H04L 1/00* (2006.01)     *H04L 1/1867* (2023.01)
*H04L 1/20* (2006.01)

(52) Cooperative Patent Classification (CPC):
**H04L 1/0045; H04L 1/0057; H04L 1/1896;**
**H04L 1/203;** H04L 1/0061

(86) International application number:
**PCT/CN2021/101094**

(87) International publication number:
**WO 2021/254508 (23.12.2021 Gazette 2021/51)**

(54) **METHOD AND APPARATUS FOR DETERMINING CODE BLOCK LOSS**

VERFAHREN UND VORRICHTUNG ZUR BESTIMMUNG VON CODEBLOCKVERLUST

PROCÉDÉ ET APPAREIL DESTINÉS À DÉTERMINER UNE PERTE DE BLOC DE CODE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority:  **20.06.2020   CN 202010569870**

(43) Date of publication of application:
**05.04.2023 Bulletin 2023/14**

(73) Proprietor: **Huawei Technologies Co., Ltd.**
**Longgang District,**
**Shenzhen,**
**Guangdong 518129 (CN)**

(72) Inventors:
  • **LI, Rixin**
    **Shenzhen, Guangdong 518129 (CN)**
  • **ZHONG, Qiwen**
    **Shenzhen, Guangdong 518129 (CN)**
  • **XU, Li**
    **Shenzhen, Guangdong 518129 (CN)**
  • **ZHU, Zhigang**
    **Shenzhen, Guangdong 518129 (CN)**
  • **ABBAS, Ghani**
    **Nottingham Nottinghamshire NG82PX (GB)**

(74) Representative: **Maiwald GmbH**
**Engineering**
**Elisenhof**
**Elisenstrasse 3**
**80335 München (DE)**

(56) References cited:
**CN-A- 102 224 702      CN-A- 109 905 198**
**CN-A- 110 800 229      US-A1- 2011 188 380**
**US-A1- 2018 278 368      US-A1- 2020 091 932**

• **HAIYAN ZHANG HUAWEI TECHNOLOGIES CO**
**ET AL: "Proposal for MPLS Packet Loss**
**Measurement;WD", ITU-T DRAFT ; STUDY**
**PERIOD 2005-2008, INTERNATIONAL**
**TELECOMMUNICATION UNION, GENEVA ; CH,**
**vol. 5/13, 14 April 2006 (2006-04-14), pages 1 - 2,**
**XP017524525**
• **QIWEN ZHONG HUAWEI TECHNOLOGIES CO ET**
**AL: "MTN path layer BER**
**monitoring;WD1112-53", vol. 11/15,12/15, 9**
**September 2019 (2019-09-09), pages 1 - 8,**
**XP044275883, Retrieved from the Internet**
**<URL:https://www.itu.int/ifa/t/2017/sg15/**
**exchange/wp3/2019-09-Gothenburg-Q11-Q12/**
**wd/WD1112-53_huawei_MTN%20path%20layer%**
**20BER%20monitoring.docx> [retrieved on**
**20190909]**

- HUAWEI, HISILICON: "Consideration on subsequent transmission/retransmission after pre-emption", 3GPP DRAFT; R1-1706915, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE, vol. RAN WG1, no. Hangzhou, China; 20170515 - 20170519, 14 May 2017 (2017-05-14), Mobile Competence Centre ; 650, route des Lucioles ; F-06921 Sophia-Antipolis Cedex ; France
, XP051272145

**Description**

This application claims priority to Chinese Patent Application No. 202010569870.6, filed with the China National Intellectual Property Administration on June 20, 2020 and entitled "BLOCK GROUP LOSS DETERMINING METHOD AND APPARATUS.

**TECHNICAL FIELD**

This application relates to the field of communication technologies, and in particular, to a block group loss determining method and an apparatus.

**BACKGROUND**

Error performance of a physical layer of a communication apparatus is an important factor that determines transmission quality. Because the error performance is an important indicator of network transmission quality, the International Telecommunication Union (International Telecommunication Union-Telecommunication Standardization Sector, ITU-T) issues many recommendations on error parameters and targets, including a definition of a block error detection principle for error detection code (error detection code, EDC) inserted into a tested path.

Bit interleaved parity (Bit interleaved parity, BIP) is a typical error detection technology in a telecommunication network technology, and includes odd parity and even parity. For example, a receive end may detect, by comparing a received parity bit with a locally calculated parity bit, whether a bit error occurs in a signal flow. If a result of the received parity bit is consistent with a result of the locally calculated parity bit, no bit error occurs in the signal flow. If the result of the received parity bit is inconsistent with the result of the local calculation parity bit, the bit error occurs in the signal flow. In actual application, there may be one or more parity bits. There are eight frequently-used parity bits, such as BIP8.

However, a parity bit calculated by the receive end is usually inaccurate, and therefore, a bit error status determined by the receive end is inaccurate.

US2011188380 A1 discloses that packet loss is measured at the receiver. A transmitter periodically transmits Operation, Administration, and Maintenance, OAM, packets to the receiver containing information about the number of transmitted data packets. The receiver counts the number of received data packets between two consecutive OAM packets, and computes the packet loss ratio as the ratio of the difference between the number of transmitted packets and the number of received packets, to the number of transmitted packets.

"Proposal for MPLS Packet Loss Measurement" from Haiyan Zhang, Huawei Technologies, ITU-T Study Group 13 - Series WD, 14/04/2006 discloses that packets transmitted counts are periodically transmitted in CV, FFD and OAM packets in a flow of data packet. This enables the receiver to compute the packet loss ratio as the ratio of the difference between the number of transmitted packets and the number of received packets between consecutive CV/ FFD/OAM packets, to the number of transmitted packets.

"MTN path layer BER monitoring" from Qiwen ZHONG Huawei Technologies, ITU-T Draft; Study Period 2017-2020; Study Group 15; Series WD1112-53, 09/09/2019, discusses computation of bit error rate for MTN. A C1472 66B block called BIP8 is used to indicate boundaries of a group of 64B/66B codewords transmitted over a MTN path. BIP8 carries 8 bits of Byte Interleaving Parity, each bit enabling to detect one error in one of the 8 bytes of the 64B/66B codewords of the group. The CRC in the BIP8 block is not sent immediately after the corresponding group of 64B/66B codewords, but after two other consecutive groups of 64B/66B codewords.

US 2020091932 A1 discloses receiving a first boundary bit block, i.e. a 64B/66B block, followed by T bit blocks and by another boundary bit block. The receiver compares two check results computed locally based on the received T bit blocks, with two check results received in a boundary bit block, to determine whether errors have occurred. The check results are determined using bit interleaved parity, BIP, considering different amount of consecutive bits (m and n).

**SUMMARY**

This application provides a block group loss determining method and an apparatus, so that a quantity of lost block groups can be effectively determined. The invention is set out in the appended set of claims.

According to a first aspect, an embodiment of this application provides a block group loss determining method, and the method includes: receiving at least two block groups, where the at least two block groups include at least two boundary block groups, and the at least two boundary block groups include a first boundary block group and a second boundary block group; obtaining a receiving quantity of first block groups between the first boundary block group and the second boundary block group, where the first block group is included in the at least two block groups; obtaining a target quantity of first block groups between the first boundary block group and the second boundary block group; and determining a quantity of lost block groups based on the receiving quantity and the target quantity.

In this embodiment of this application, a receive end can not only identify the boundary block group, but also obtain a quantity of first block groups between two boundary block groups, to obtain the receiving quantity. Through comparison between the target quantity and the receiving quantity, the quantity of lost block groups and a line bit error status of a first path can be obtained.

In a possible implementation, a length of each of the at least two block groups is a preset length.

In this embodiment of this application, the block group is encapsulated by using a fixed length, so that a relationship between a block group loss rate and a line bit error rate is no longer random, but is determined.

In a possible implementation, each of the at least two block groups includes at least three blocks, the blocks include a start block, a data block, and an end block, and the block group starts with the start block and ends with the end block. The block is a P1 B/P2 B block, P1 represents a quantity of payload bits of the block, P2 represents a total quantity of bits in the block, and P2-P1 represents a quantity of synchronization header bits of the block.

In this embodiment of this application, the block group is simulated as an ethernet packet, so that the block group can be compatible with rate adaptation of an MTN path, and compatibility of client signal flow transmission is ensured.

In a possible implementation, each of the at least two block groups includes cyclic redundancy check CRC information.

In a possible implementation, each of the at least two block groups is a block group for which CRC information check succeeds.

In a possible implementation, a bit length of the CRC information includes any one of the following: 4 bits, 8 bits, 16 bits, or 32 bits.

In a possible implementation, each of the at least two block groups further includes payload information and/or overhead information.

In a possible implementation, the boundary block group includes first overhead information, and the first overhead information is used to identify the boundary block group.

In this embodiment of this application, the first overhead information may be a flag bit (or referred to as flag information), and the flag bit is used to identify the boundary block group. In this case, the receive end may identify the boundary block group by using the flag bit.

In a possible implementation, the boundary block group further includes fourth overhead information, and the fourth overhead information indicates the target quantity.

In this embodiment of this application, the fourth overhead information indicates the target quantity. For example, the fourth overhead information includes a first quantity and/or a second quantity. In this case, the receive end may identify the boundary block group by using the first quantity and/or the second quantity.

For example, the first overhead information and the fourth overhead information may be located at a same location (or referred to as a field or the like) in the block group; or the first overhead information and the fourth overhead information may alternatively be located at different locations in the block group. This is not limited in this embodiment of this application. When the first overhead information and the fourth overhead information are located at a same location in the block group, the receive end not only obtains the target quantity, but can also identify the boundary block group.

In this embodiment of this application, the target quantity may be specified in a protocol, or may be preset by a communication apparatus (for example, including a transmit end and the receive end), or the target quantity is indicated by using the fourth overhead information. Whether quantities of first block groups between every two adjacent boundary block groups are the same is not limited in this embodiment of this application.

In a possible implementation, the fourth overhead information includes the first quantity and/or the second quantity.

In a possible implementation, the target quantity is a sum of the first quantity and the second quantity, and the determining a quantity of lost block groups based on the receiving quantity and the target quantity includes: when the receiving quantity is greater than the first quantity or the receiving quantity is greater than the second quantity, determining the quantity of lost block groups based on the target quantity and the receiving quantity.

In this embodiment of this application, the first overhead information and the fourth overhead information are encapsulated in the boundary block group, so that the receive end can distinguish between the boundary block group and the first block group, and therefore the receive end can accurately obtain the receiving quantity. Further, the target quantity is indicated by using the fourth overhead information, so that the receive end can further obtain a quantity of first block groups that are between two boundary block groups and that are actually sent by the transmit end, and therefore the receive end can accurately obtain the quantity of lost block groups.

In a possible implementation, the first block group includes second overhead information, and the second overhead information is used to identify the boundary block group.

In this embodiment of this application, the first block group includes the second overhead information, so that the receive end can distinguish between the boundary block group and the first block group. In this case, the target quantity may be specified in a protocol, or may be preset by the communication apparatus, or the second overhead information indicates the target quantity. It may be understood that for an implementation of the second overhead information, refer to the first overhead information. Details are not described herein again. For example, the first block group may further include fifth overhead information, and the fifth overhead information indicates the target quantity. For an implementation of the fifth overhead information, further refer to the fourth overhead information. Details are not described herein again.

In a possible implementation, each of the at least two block groups includes third overhead information, and the third overhead information is used to identify the boundary block group.

In this embodiment of this application, each block group includes the third overhead information, and third overhead information in two boundary block groups adjacent to the first block group is different from third overhead information in the first block group.

In a possible implementation, the boundary block group is identified by using a change of the third overhead information.

In a possible implementation, the third overhead information is a bit sequence.

In a possible implementation, the third overhead information is sequence number information, and the obtaining a target quantity of first block groups between the first boundary block group and the second boundary block group includes: determining the target quantity by using a difference between third overhead information in the first boundary block group and third overhead information in the second boundary block group.

In a possible implementation, the receiving at least two block groups includes: receiving the at least two block groups by using a first path, where the first path includes M first slots, the M first slots are included in a second path, the second path includes N second slots, the N second slots are included in a bundle group, the bundle group includes one or more physical layer PHY links, bandwidth of the second slot is greater than bandwidth of the first slot, and both M and N are integers greater than or equal to 1.

In a possible implementation, the bandwidth of the second slot is 5 Gbps or 25 Gbps, and the bandwidth of the first slot is any one of the following: 2.5 Mbps, 10 Mbps, or 100 Mbps.

In this embodiment of this application, the first path may multiplex a slot of the second path, so that the first path can transmit a fine-grained service, and therefore the first path has a smaller and finer slot granularity.

In a possible implementation, after the determining a quantity of lost block groups based on the receiving quantity and the target quantity, the method further includes: determining a line bit error rate based on a quantity of lost block groups in a detection window.

In a possible implementation, after the determining a quantity of lost block groups based on the receiving quantity and the target quantity, the method further includes: obtaining a quantity of lost block groups in a detection window; and initiating an alarm signal when the quantity of lost block groups in the detection window is greater than or equal to a first threshold; or eliminating the alarm signal when the quantity of lost block groups in the detection window is less than or equal to a second threshold.

According to a second aspect, an embodiment of this application provides a block group sending method, and the method includes: generating at least two block groups, where the at least two block groups include at least two boundary block groups, and the at least two boundary block groups include a first boundary block group and a second boundary block group; and sequentially sending the first boundary block group, a first block group between the first boundary block group and the second boundary block group, and the second boundary block group.

In this embodiment of this application, for descriptions of the boundary block group, the first block group, first overhead information, second overhead information, third overhead information, and a target quantity, refer to the first aspect. Details are not described herein again.

In a possible implementation, the generating at least two block groups includes: generating the at least two block groups at an MTN fg layer.

In a possible implementation, the sequentially sending the first boundary block group, a first block group between the first boundary block group and the second boundary block group, and the second boundary block group includes: sequentially sending the first boundary block group, the first block group between the first boundary block group and the second boundary block group, and the second boundary block group on a first path.

According to a third aspect, an embodiment of this application provides a communication apparatus, configured to implement the method in the first aspect or any possible implementation of the first aspect. The communication apparatus includes corresponding units for performing the method in the first aspect or any possible implementation of the first aspect, or for performing the method in the second aspect or any possible implementation of the second aspect. The communication apparatus includes corresponding units for performing the method in the second aspect or any possible implementation of the second aspect.

For example, the communication apparatus may include a transceiver unit and a processing unit.

According to a fourth aspect, an embodiment of this application provides a communication apparatus. The communication apparatus includes a processor, configured to execute a program stored in a memory, and when the program is executed, the communication apparatus is enabled to perform the method in the first aspect or any possible implementation of the first aspect, or the communication apparatus is enabled to perform the method in the second aspect or any possible implementation of the second aspect.

In a possible implementation, the memory is located outside the communication apparatus.

In a possible implementation, the memory is located inside the communication apparatus.

In a possible implementation, the communication apparatus further includes a transceiver, and the transceiver is configured to receive a signal or send a signal. For example, the transceiver receives at least two block groups or the like.

According to a fifth aspect, this application provides a communication apparatus. The communication apparatus includes a processing circuit and an interface circuit, and the interface circuit is configured to obtain data or output data. The processing circuit is configured to perform a corresponding method in the first aspect or any possible implementation of the first aspect; or the processing circuit is configured to perform a corresponding method in the second aspect or any possible implementation of the second aspect.

According to a sixth aspect, an embodiment of this application provides a computer-readable storage medium. The computer-readable storage medium is configured to store a computer program, and when the computer program is run on a computer, the method shown in the first aspect or any possible implementation of the first aspect is performed, or the method shown in the second aspect or any possible implementation of the second aspect is performed.

Alternatively, the computer-readable storage medium is configured to store a computer program, and when the computer program is run, the method shown in the first aspect or any possible implementation of the first aspect is performed, or the method shown in the second aspect or any possible implementation of the second aspect is performed.

According to a seventh aspect, an embodiment of this application provides a computer program product. The computer program product includes a computer program or computer code, and when the computer program product is run on a computer, the method shown in the first aspect or any possible implementation of the first aspect is performed, or the method shown in the second aspect or any possible implementation of the second aspect is performed.

Alternatively, the computer program product includes a computer program or computer code, and when the computer program or the computer code is run, the method shown in the first aspect or any possible implementation of the first aspect is performed, or the method shown in the second aspect or any possible implementation of the second aspect is performed.

According to an eighth aspect, an embodiment of this application provides a computer program. When the computer program is run on a computer, the method shown in the first aspect or any possible implementation of the first aspect is performed, or the method shown in the second aspect or any possible implementation of the second aspect is performed.

Alternatively, when the computer program is run, the method shown in the first aspect or any possible implementation of the first aspect is performed, or the method shown in the second aspect or any possible implementation of the second aspect is performed.

According to a ninth aspect, an embodiment of this application provides a communication system. The communication system includes a transmit end and a receive end, and the receive end may also be configured to perform the related method shown in the first aspect.

Optionally, the communication system may further include an intermediate node. It may be understood that for specific implementations of the transmit end and the receive end, refer to the following descriptions. Details are not described herein.

**BRIEF DESCRIPTION OF DRAWINGS**

FIG. 1 is a schematic diagram of a communication system based on a flexible ethernet protocol according to an embodiment of this application;

FIG. 2 is a schematic diagram of an MTN network architecture according to an embodiment of this application;

FIG. 3 is a schematic diagram of three different network architectures according to an embodiment of this application;

FIG. 4a shows definitions of different code types of a 64B/66B block according to an embodiment of this application;

FIG. 4b is a schematic diagram of a structure of a block group according to an embodiment of this application;

FIG. 4c is a schematic diagram of comparison between a structure of a block group and a structure of an ethernet MAC frame according to an embodiment of this application;

FIG. 5a is a schematic diagram of a first path and a second path according to an embodiment of this application;

FIG. 5b is a schematic diagram of a first path and a second path according to an embodiment of this application;

FIG. 6a is a schematic diagram of an MTN network architecture according to an embodiment of this application;

FIG. 6b is a schematic diagram of a communication system according to an embodiment of this application;

FIG. 7a is a schematic flowchart of a block group loss determining method according to an embodiment of this application;

FIG. 7b is a schematic diagram of a method for distinguishing between a boundary block group and a first block group according to an embodiment of this application;

FIG. 8a is a schematic flowchart of a block group loss determining method according to an embodiment of this application;

FIG. 8b is a schematic diagram of a scenario in which a transmit end sends a block group according to an embodiment of this application;

FIG. 8c is a schematic diagram of a scenario in which a receive end receives a block group according to an embodiment of this application;

FIG. 9a is a schematic flowchart of a block group loss determining method according to an embodiment of this application;

FIG. 9b is a schematic diagram of a scenario in which a transmit end sends a block group according to an embodiment of this application;

FIG. 9c is a schematic diagram of a scenario in which a receive end receives a block group according to an embodiment of this application;

FIG. 10a is a schematic flowchart of a block group loss determining method according to an embodiment of this application;

FIG. 10b is a schematic diagram of a scenario in which a transmit end sends a block group according to an embodiment of this application;

FIG. 10c is a schematic diagram of a scenario in which a receive end receives a block group according to an embodiment of this application;

FIG. 10d is a schematic diagram of a relationship between a block group sequence number and a quantity of lost block groups according to an embodiment of this application;

FIG. 11 is a schematic flowchart of a block group loss determining method according to an embodiment of this application;

FIG. 12 is a schematic diagram of a structure of a communication apparatus according to an embodiment of this application;

FIG. 13 is a schematic diagram of a structure of a communication apparatus according to an embodiment of this application; and

FIG. 14 is a schematic diagram of a structure of a communication apparatus according to an embodiment of this application.

## DESCRIPTION OF EMBODIMENTS

To make the objectives, technical solutions, and advantages of this application clearer, the following further describes this application with reference to the accompanying drawings.

In the description, claims, and accompanying drawings of this application, the terms "first", "second", and so on are intended to distinguish between different objects but do not indicate a particular order. In addition, the terms "including" and "having" and any other variants thereof are intended to cover a non-exclusive inclusion. For example, a process, a method, a system, a product, or a device that includes a series of steps or units is not limited to the listed steps or units, but optionally further includes an unlisted step or unit, or optionally further includes another step or unit inherent to the process, the method, the product, or the device.

"Embodiment" mentioned in this specification means that a particular feature, structure, or characteristic described with reference to the embodiment may be included in at least one embodiment of this application. The phrase shown in various locations in the specification may not necessarily refer to a same embodiment, and is not an independent or optional embodiment exclusive from another embodiment. It is explicitly and implicitly understood by a person skilled in the art that embodiments described in the specification may be combined with another embodiment.

In this application, "at least one" means one or more, "a plurality of" means two or more, "at least two" means two or three or more, and "and/or" is used to describe an association relationship of associated objects, and indicates that three relationships may exist. For example, "A and/or B" may represent: Only A exists, only B exists, and both A and B exist, where A and B may be singular or plural numbers. The character "/" usually indicates an "or" relationship between associated objects. "At least one of the following items" or a similar expression means any combination of these items. For example, at least one of a, b, or c may represent a, b, c, "a and b", "a and c", "b and c", or "a, b, and c".

Some of terms in this application are described in detail below.

1. Flexible ethernet (flexible ethernet, FlexE)

The optical internet forum (optical internet forum, OIF) releases a flexible ethernet (flexible ethernet, FlexE), and the FlexE is a general technology that supports different ethernet media access control (media access control, MAC) layer rates. A concept of a flexible ethernet bundle group (also referred to as FlexE group or simply referred to as a bundle group) is introduced into the FlexE. The bundle group may include one or more physical layer apparatuses (which may also be considered as physical link interfaces, and may be denoted as PHY). A bandwidth resource corresponding to one bundle group is a sum of bandwidth resources corresponding to PHYs in the bundle group. Therefore, based on the bundle group, the FlexE can meet a higher transmission rate and higher transmission bandwidth.

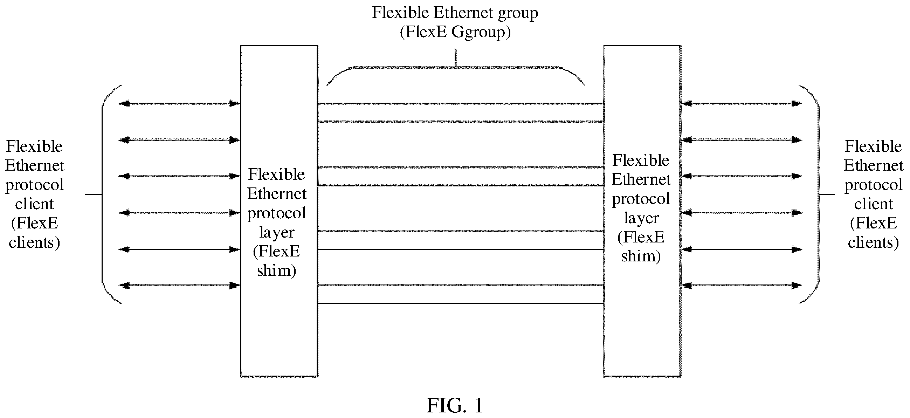

FIG. 1 is, for example, a schematic diagram of a communication system based on a flexible ethernet protocol. In FIG. 1, for example, one bundle group includes four PHYs. The FlexE divides a bandwidth resource of each PHY into a plurality of slots in a time division multiplexing (time division multiplexing, TDM) manner, to implement hard isolation of transmission pipeline bandwidth. A flexible ethernet protocol client (FlexE Client) represents a service flow transmitted in a slot (one or more slots) specified on a bundle group, one bundle group may carry a plurality of flexible ethernet protocol clients, one flexible ethernet protocol client corresponds to one service flow (which may typically be referred to as a medium access control (medium access control, MAC) Client), and a flexible ethernet protocol functional layer (also referred to as FlexE shim) provides data adaptation and conversion from the flexible ethernet protocol client to the MAC client.

The FlexE supports functions such as binding, a sub-rate, and channelization by binding a plurality of PHYs. For example, the FlexE may bind a plurality of 100 gigabit ethernet (gigabit ethernet, GE) PHY ports, and divide each 100 GE port into 20 slots in time domain by using 5G as a granularity. The FlexE may support services at different ethernet MAC rates. For example, a $2\times100$ GE bundle group supports a MAC service of 200 G; to be specific, the FlexE binds a plurality of ethernet ports into one bundle group (group) to support a MAC service whose rate is greater than that of a single ethernet port; in other words, the FlexE supports a binding function. For another example, transmission of a MAC service of 50G in a 100 GE bundle group is supported; to be specific, a slot is allocated to the service to support a MAC service whose rate is less than bandwidth of the bundle group or less than bandwidth of a single ethernet port; in other words, the FlexE supports a sub-rate function. For another example, a $2\times100$ GE bundle group supports simultaneous transmission of one 150G service and two 25G MAC services; to be specific, a slot is allocated to the service to support simultaneous transmission of a plurality of MAC services in the bundle group; in other words, the FlexE supports a channelization function.

It can be learned that the FlexE may transmit a plurality of service flows in parallel by using the bundle group, and service data of a same service flow may be carried on one PHY in the bundle group, or may be carried on different PHYs in the bundle group. In other words, service data of a same service flow may be transmitted to a peer end by using one PHY in the bundle group, or may be transmitted to a peer end by using a plurality of PHYs in the bundle group. A bandwidth resource of one PHY is generally divided into a plurality of slots. In actual use, service data is encapsulated in the slot, and then, the slot is mapped to the PHY in the bundle group.

It may be understood that the bundle group shown in this application may also be referred to as a link group or the like, and the service flow shown in this application may also be referred to as a data flow. Names of the bundle group and the service flow are not limited in this application.

2. Metro transport network (metro transport network, MTN)

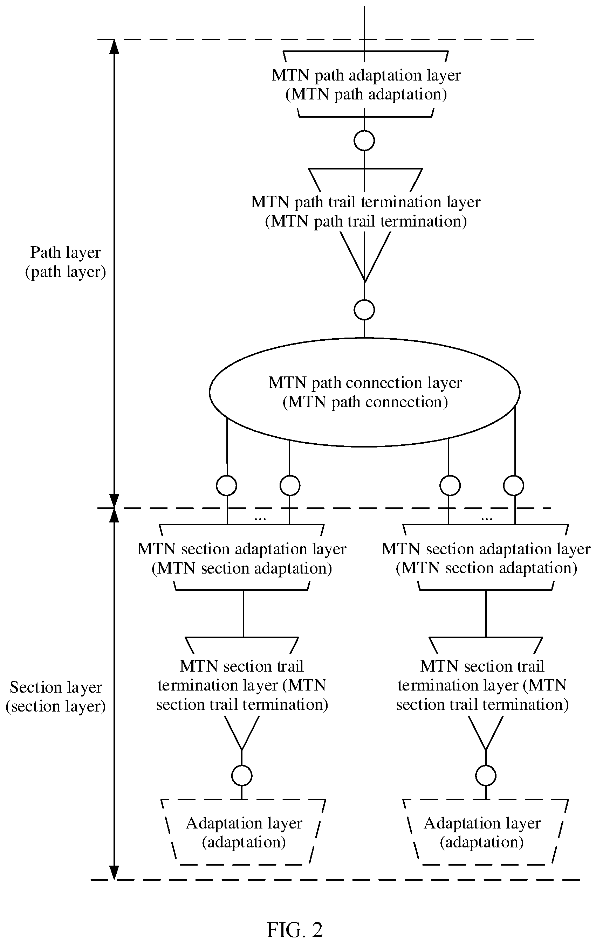

The MTN is a next-generation transport network technology system defined by the International Telecommunication Union (telecommunication standardization sector of itu, ITU-T) for a new service requirement such as 5G by still using FlexE design logic. For example, as shown in FIG. 2, the MTN may include an MTN path layer (MTN path layer) and an MTN section layer (MTN section layer). The MTN path layer includes an MTN path adaptation layer (MTN path adaptation), an MTN path trail termination layer (MTN path trail termination), an MTN path connection layer (MTN path connection), and the like. The MTN section layer includes an MTN section adaptation layer (MTN section adaptation) and an MTN section trail termination layer (MTN section trail termination). Optionally, the MTN section layer may further include an adaptation layer (adaptation).

It may be understood that the MTN path adaptation layer, the MTN path trail termination layer, the MTN path connection layer, the MTN section trail termination layer, or the like may have another name. For example, the MTN path adaptation layer may also be referred to as an MTN path adaptation function module. This is not limited in this application. It may be understood that for descriptions of the bundle group in the MTN, refer to descriptions of the bundle group in the FlexE. Details are not described herein again.

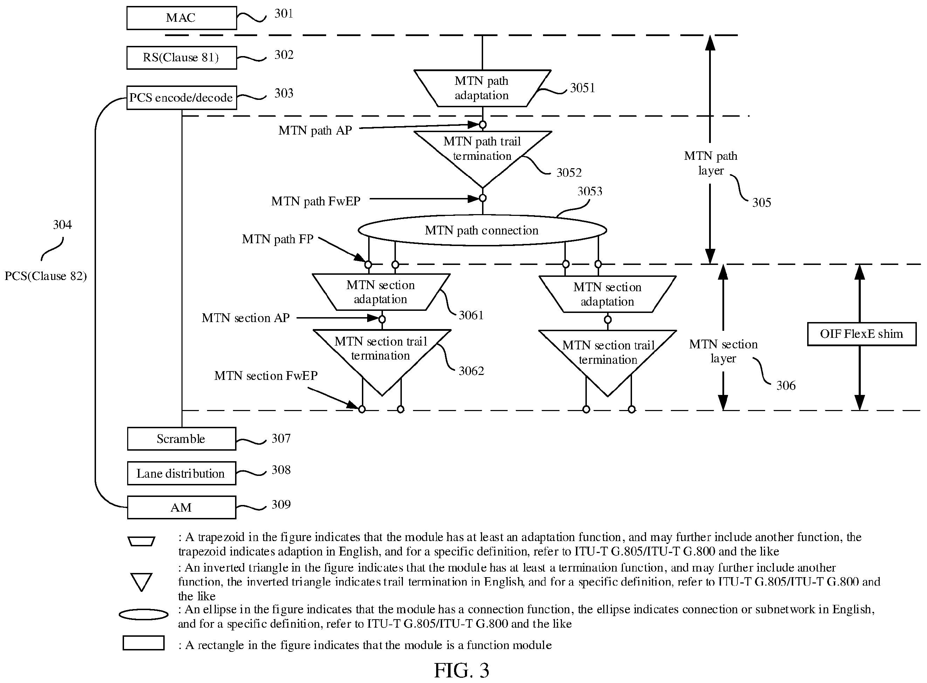

As shown in FIG. 3, a service flow obtained by a transmit end may enter an MTN path adaptation layer 3051 in an MTN domain through MAC 301 and is adapted into a form of a 64B/66B block flow. After the 64B/66B block flow enters an MTN path trail termination layer 3052, operations, administration, and maintenance (operations, administration, and maintenance, OAM) information is inserted into the 64B/66B block flow, and the OAM information includes a bit interleaved parity (bit interleaved parity, BIP) result.

Then, the transmit end may perform layer 1.5 forwarding by using an MTN path connection layer (MTN path connection) 3053, that is, determine a correspondence between an egress port and an ingress port at the MTN path connection layer, to determine the egress port. An MTN section adaptation layer (MTN section adaptation) 3061 is an adaptation function from a path layer to a section layer. Each MAC service flows (for example, in a form of a 64B/66B block) at the MTN section adaptation layer are interleaved to form a 64B/66B block flow. Then, the 64B/66B block flow passes through an MTN section trail termination layer (MTN section trail termination) 3062, and overhead information such as section layer OAM is inserted. Then, the 64B/66B block flow passes through an adaptation layer (adaptation) and enters a physical layer for transmission and the like. For example, the 64B/66B block flow may further pass through scramble code 307, lane distribution 308, and an alignment marker (alignment marker, AM) insertion function 309 in FIG. 3. On the contrary, after a receive end receives the 64B/66B block flow, a flowing direction of the 64B/66B block flow received by the receive end is opposite to a flowing direction of a 64B/66B block flow sent by the transmit end. For example, the 64B/66B block flow received by the receive end may sequentially pass through, for example, an MTN section layer and an MTN path layer.

As shown in FIG. 3, roughly from a perspective of a protocol stack, the MTN section layer is similar to OIF FlexE shim in terms of a function. A current version of the MTN section layer reuses the FlexE and is compatible with the FlexE. A FlexE frame format is reserved for a frame format of the MTN section layer of the current version.

It may be understood that for specific descriptions of the MAC 301, a reconciliation sublayer (reconciliation sublayer, RS) 302, and physical coding sublayer encode/decode (PCS encode/decode) 303 in FIG. 3, refer to an ethernet model in the IEEE 802.3.

3. Block (block)

P1 B/P2 B block: This is an encoding manner that may also be referred to as a P1 B/P2 B bit block (bit block), a P1 B/P2 B code block, a P1 B/P2 B bit flow, a P1/P2 (or P1 b/P2 b) bit block, or the like. P1 represents a quantity of payload bits in a block (or a bit block), P2 represents a total quantity of bits in the block, P2-P1 represents a quantity of synchronization header bits in the block, P1 and P2 are positive integers, and P2 is greater than P1. For example, the P1 B/P2 B block may be an 8B/10B block, a 64B/66B block, a 128B/130B block, or a 256B/258B block. Specific values of P1 and P2 are not limited in this application.

A 64B/66B block is used as an example below to show the method provided in this application. It may be understood that the 64B/66B block shown below may also be replaced with a 64B/66B bit block, a 64/66 block, a 64/66 bit block, a 64b/66b block, a 64b/66b bit block, a 64B/66B bit block flow, a 64B/66B code block, or the like.

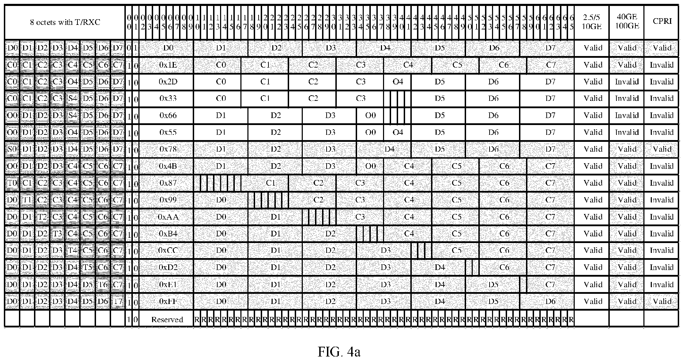

As an example, FIG. 4a shows definitions of different code types of the 64B/66B block. As shown in FIG. 4a, two bits "10" or "01" in a header are synchronization header bits, and last 64 bits are payload bits and may be used to carry payload data or the like. In FIG. 4a, each row represents a definition of a code type, where D0 to D7 represent data bytes, C0 to C7 represent control bytes, S0 represents a start of a MAC frame, and T0 to T7 represent an end of the MAC frame.

4. Block group (block group)

The block group may include one start block, one or more data blocks, and one end block. For example, a start part of the block group is the start block, and an end part is the end block. In other words, a first block in the block group is the start block, and a last block is the end block. In this application, a length of the block group may be a preset length. For example, a length of a data block in a block group may be 128 bytes, 192 bytes, 256 bytes, or 384 bytes. In other words, if a synchronization header in each block is not taken into consideration, a preset length of the block group may be 144 bytes, 208 bytes, 272 bytes, 400 bytes, or the like. A specific length of the block group is not limited in this application. Optionally, each block group is the same in length. For example, the block group may include one start block, P data blocks, and one end block, and a value of P may be any one of 16, 24, 32, 48, or the like.

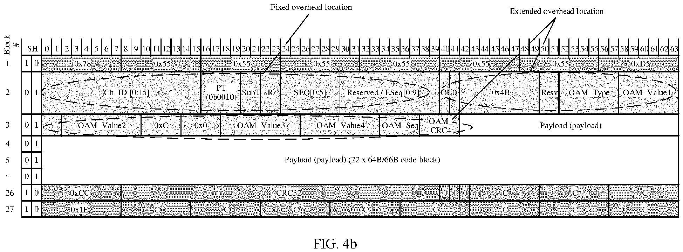

For example, FIG. 4b is a schematic diagram of a block group. As shown in FIG. 4b, a first row (that is, corresponding to the start block in FIG. 4a) is a start block in the block group, a 26th row (that is, corresponding to the end block in FIG. 4a) is an end block in the block group, and a second row to a 25th row are data blocks in the block group. For example, the block group includes payload information and overhead information, and the payload information may be service data. A payload (payload) location shown in FIG. 4b may be used to carry the payload information. The overhead information may also be referred to as operations, administration, and maintenance (operations, administration, and maintenance, OAM) information, or the overhead information may also be referred to as other information. A name of the overhead information is not limited in this application. A fixed overhead location and an expanded overhead location shown in FIG. 4b may be used to carry the overhead information. It may be understood that the fixed overhead location and the expanded overhead location shown in FIG. 4b are merely examples. In specific implementation, the fixed overhead location and the expanded overhead location may not be distinguished from each other. As an example, after obtaining the block group, a communication apparatus may directly extract overhead information carried at the fixed overhead location. The communication apparatus may be indicated, by using a flag bit, flag information, or the like, to obtain overhead information carried at the expanded overhead location. To be specific, after obtaining the block group, the communication apparatus may extract, by using the flag bit, the flag information, or the like, the overhead information carried at the expanded overhead location. Therefore, a case in which the overhead information is not carried at the expanded overhead location, but the communication apparatus still detects the expanded overhead location can be avoided.

It may be understood that the overhead information shown in this application may also be referred to as fgDU overheads, and the payload information may also be referred to as fgDU payload. This is not limited in this application.

In this application, the block group may further include CRC information. In some cases, the CRC information may also be referred to as overhead information of the block group. However, the CRC information is mainly described in this application. Therefore, the CRC information and the overhead information are separately described in this application, but this cannot be used as a limitation in this application. It may be understood that the overhead information or the CRC information in this application may be carried on the start block, the data block, or the end block. This is not limited in this application. In the example shown in FIG. 4b, the CRC information is carried on the end block.

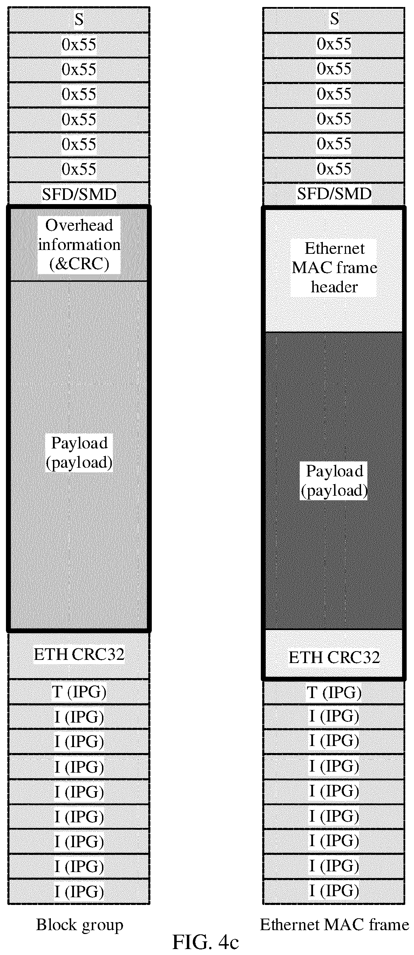

Similarly, as shown in FIG. 4c, a schematic diagram of a block group is shown on a left side of FIG. 4c, and a schematic diagram of an ethernet MAC frame is shown on a right side of FIG. 4c. It may be learned from FIG. 4c that a structure of the block group shown in this application is similar to a structure of the ethernet MAC frame. In this application, the block group is simulated (or disguised) as the ethernet MAC frame, so that the block group can be compatible with a rate adaptation manner of an MTN path, and compatibility of client signal flow transmission is ensured.

An idle (idle) block shown in FIG. 4b or FIG. 4c may be understood as being added due to rate adaptation. However, a length of the idle block may not be considered in the length of the block group, or a quantity of idle blocks may not be counted when the receive end obtains a receiving quantity. Alternatively, when the communication apparatus needs to perform rate adaptation, an idle block group may be added or deleted, and the idle block group starts with a start block and ends with an end block. In addition, when determining the receiving quantity, the receive end may not count a quantity of idle block groups. In this case, accuracy of a quantity of lost block groups obtained by the receive end can be effectively improved. It may be understood that the foregoing descriptions are merely an example. In specific implementation, the length of the idle block may also be considered in the length of the block group, or the receive end counts the quantity of idle block groups in the receiving quantity. This is not limited in this application. It may be understood that descriptions of the idle block or the idle block group are also applicable to another control block.

The foregoing descriptions of the block group are applicable to a first block group and a boundary block group in embodiments of this application. For a difference between the first block group and the boundary block group, refer to the following embodiments. Details are not described herein. For example, overhead information in the boundary block group may include first overhead information (this may be referred to as that the boundary block group includes the first overhead information for short below), or overhead information in the boundary block group may further include fourth overhead information. For example, overhead information in the first block group may include second overhead information (this may be referred to as that the first block group includes the second overhead information for short below), or overhead information in the first block group may further include fifth overhead information. For example, both the overhead information in the boundary block group and the overhead information in the first block group include third overhead information, but third overhead information included in a boundary block group adjacent to the first block group is different from the third overhead information included in the first block group.

It may be understood that the block group shown in this application may also be referred to as a finer granularity data unit (finer granularity data unit, fgDU), a block set, a block cluster, or the like. A name of the block group is not limited in this application.

5. CRC information

The CRC information shown in this application may be used to check integrity of the block group. For example, the receive end may process CRC information in the received block group by using a modulo 2 division method. If there is no remainder in a result obtained after processing, it indicates that it is learned through check that the block group is correct or the check succeeds. If there is a remainder in the result obtained after processing, it indicates that it is learned through check that the block group is wrong or the check fails. The receive end performs CRC check on the block group. If check on the block group succeeds, it indicates that the block group is correctly transmitted or that the block group has integrity or the like.

In this application, a bit length of the CRC information may include 4 bits, 8 bits, 16 bits, 32 bits, and the like. In other words, the CRC information shown in this application may include CRC4, CRC8, CRC16, CRC32, and the like. For example, CRC32 has a strong detection capability. The communication apparatus can basically check an error of less than four bits by using CRC32, and there is a probability of 0.9999999997671694 that the communication apparatus can check an error of more than four bits by using CRC32.

6. First path

The first path may be used to transmit the block group shown in this application, and the block group may be transparently transmitted in an MTN network. For example, the first path may provide a finer granularity end-to-end TDM path transmission service for a client signal, for example, 2.5M to 5G (including 2.5M and/or 5G).

In this application, the bundle group may be formed by binding one or more PHYs, and bandwidth of the bundle group is a sum of bandwidth of the one or more PHYs. Further, the bundle group may be divided into X second slots, and bandwidth of the second slot may include 5 Gbps, 25 Gbps, or the like. A second path may include N second slots in the X second slots, the second path may be divided into Y first slots, and bandwidth of the first slot may include 2.5 Mbps, 5 Mbps, 7.5 Mbps, 10 Mbps, 100 Mbps, or the like. The first path may include M first slots in the Y first slots. N is less than or equal to X, M is less than or equal to Y, and M, N, X, and Y are all integers greater than or equal to 1.

In other words, in this application, the first path includes M first slots, the M first slots are included in the second path, the second path includes N second slots, the N second slots are included in the bundle group, and the bundle group includes one or more PHY links. The second path is divided into Y first slots, the M first slots are included in the Y first slots, the bundle group is divided into X second slots, and the N second slots are included in the X second slots. Optionally, the bandwidth of the first slot in this application may be 2.5 Mbps $\times$ K, K is an integer greater than or equal to 1, and K is less than or equal to 2048.

In other words, a slot granularity of the first path shown in this application is smaller, and the transport network technology has a smaller and finer granularity than the MTN. For example, the first path may be used to transmit a dedicated-line service.

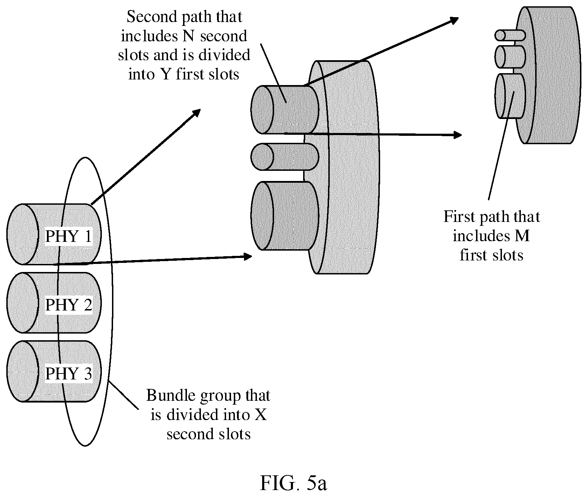

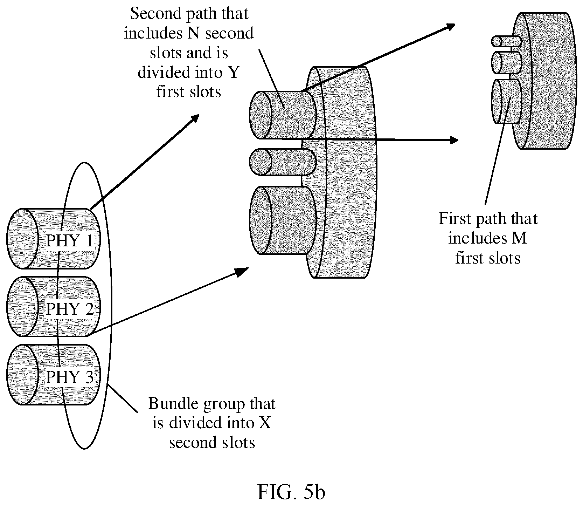

For example, as shown in FIG. 5a, one PHY in a bundle group may include three second paths, or as shown in FIG. 5b, two PHYs in a bundle group may include three second paths. A second slot included in the second path is included in the bundle group. One second path may include three first paths, for example, M first slots included in the first path are included in the second path. It may be understood that FIG. 5a and FIG. 5b are merely examples, and should not be construed as a limitation on this application.

In this application, the first path may also be referred to as an fgDU path (or an MTN fg path), a finer granularity path (or a fine-grained path), a low-order path, or the like, and the second path may also be referred to as a coarse-grained path, a high-order path, or the like. This is not limited in this application.

7. Receiving quantity and target quantity

In this application, the receiving quantity is a quantity of block groups obtained by the receive end, and the target quantity is a quantity of block groups sent by the transmit end and obtained by the receive end. In other words, the target quantity may be a quantity of block groups actually sent by the transmit end to the receive end when the transmit end sends the block groups. In a block group transmission process, a case such as loss of the block group may occur. Therefore, a quantity (that is, the receiving quantity) of block groups received by the receive end may be less than a quantity (that is, the target quantity) of block groups actually sent by the transmit end. Alternatively, in a block group transmission process, if no block group is lost, a quantity of block groups received by the receive end may be equal to a quantity of block groups actually sent by the transmit end.

It may be understood that the target quantity is a quantity of block groups actually sent by the transmit end and obtained by the receive end, but for the transmit end, the quantity of block groups actually sent by the transmit end may be referred to as a sending quantity (such as a first quantity or a second quantity shown below) for short. In embodiments shown in this application, the target quantity may be equal to the sending quantity, or the target quantity may be equal to a sum of a plurality of sending quantities.

When a 64B/66B block passes through different communication apparatuses, for example, arrives at the receive end from the transmit end, the receive end needs to determine a link bit error status based on a calculated BIP result and a BIP result sent by the transmit end, and further, determine a line bit error rate (which may also be referred to as a link bit error rate). The line bit error rate herein may be referred to as a bit error rate of a coarse-grained path, a bit error rate of the second path, or the like. Therefore, when the block group provided in embodiments of this application passes through different communication apparatuses, for example, arrives at the receive end from the transmit end, the receive end also needs to determine a block group loss status based on the received block group and the block group sent by the transmit end, and further determine a line bit error rate.

In view of this, this application provides a block group loss determining method and an apparatus. The block group loss determining method provided in this application can effectively determine a block group loss status, and further determine a line bit error rate.

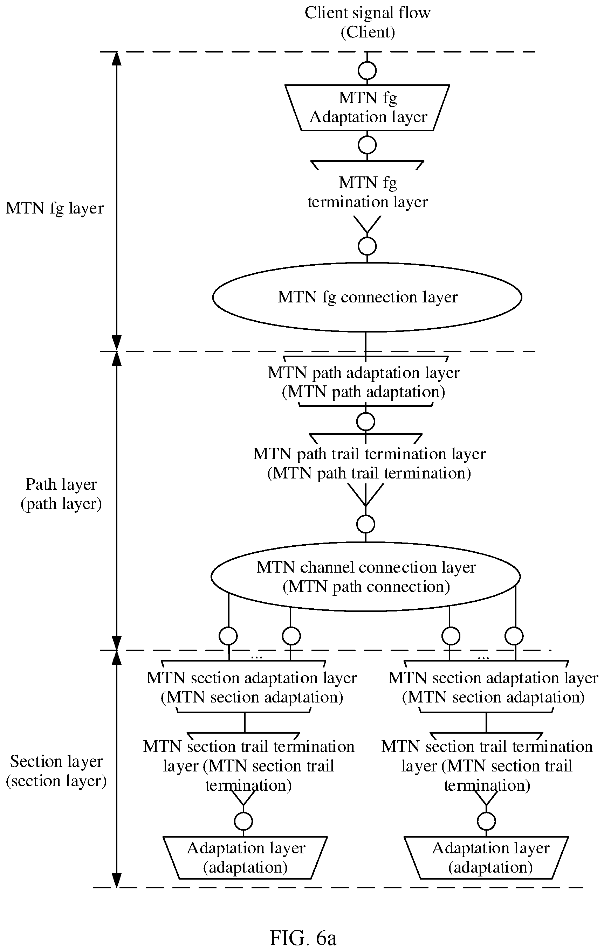

As an example, FIG. 6a is a schematic diagram of a network architecture according to an embodiment of this application. A transmit end is used as an example. A client signal flow (such as a client in FIG. 6a) passes through an MTN fg adaptation layer and then a block group flow is formed. When the block group flow passes through an MTN fg termination layer, OAM information or the like is inserted into the block group flow (which may also be understood as that overhead information is inserted). Optionally, when the block group flow passes through the MTN fg termination layer, CRC information may also be inserted into the block group flow. Then, the transmit end determines a correspondence between an ingress port and an egress port at an MTN fg connection layer, to determine the egress port. At the MTN fg termination layer, the block group flow forms a complete fine-grained path (such as a first path). Further, at an MTN path adaptation layer, one or more fine-grained paths multiplex M first slots in Y first slots that are obtained after a coarse-grained path (such as a second path) is divided. At an MTN path trail termination layer, overhead information such as OAM is inserted into one coarse-grained path, and at an MTN section adaptation layer, one or more coarse-grained paths multiplex N second slots in X second slots that are obtained after a bundle group is divided. The transmit end inserts an overhead block at every specific quantity of blocks at an MTN section trail termination layer.

The block group is encapsulated in a form of a block. Therefore, when a block group flow passes through an MTN path layer and an MTN section layer, the MTN path layer and the MTN section layer perceive a block flow. Subsequently, the block flow passes through a physical layer and is sent to a link.

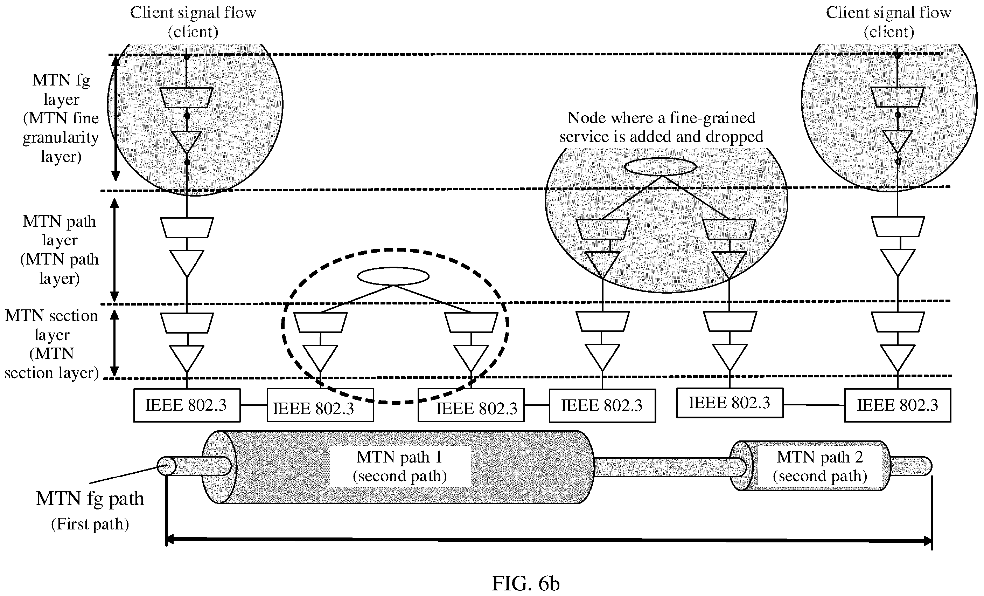

FIG. 6b is a schematic diagram of a communication system according to an embodiment of this application. For example, a network architecture shown in FIG. 6b is successively a transmit end, an intermediate node 1, an intermediate node 2, and a receive end from left to right. For a method used by the transmit end to send a block group flow, refer to descriptions in FIG. 6a.

In FIG. 6b, because the transmit end and a receive end are network edge devices (provider edge, PE), an MTN path connection layer and an MTN fg connection layer are not shown on the transmit end and the receive end. For a network device (provider, P) in a network, the intermediate node 1 shows an MTN path connection layer, and the intermediate node 2 shows an MTN fg connection layer.

After the intermediate node 1 receives a block flow through an MTN section layer or an MTN path layer, because the block flow does not pass through an MTN fg layer, the intermediate node 1 can perceive only the block flow. The intermediate node 2 may obtain a block group flow through the MTN fg layer, and the intermediate node 2 may further reselect a coarse-grained path (for example, reselect a second path), and send the block flow to the receive end through a new coarse-grained path. After receiving the block flow, the receive end extracts an overhead block from the MTN section trail termination layer, and then an MTN section adaptation function demultiplexes a coarse-grained path from N second slots in a bundle group, and an MTN path trail termination layer function demultiplexes a fine-grained path from M first slots of the coarse-grained path. In this way, the receive end may obtain overhead information (or OAM information or the like) from the fine-grained path by using a termination function of the MTN fg layer, and the MTN fg adaptation function recovers the client signal flow from the fine-grained path. It may be understood that, because a flowing direction of the client signal flow obtained by the receive end is opposite to a flowing direction of the client signal flow sent by the transmit end, for a specific manner in which the receive end obtains the client signal flow, refer to descriptions of sending the block flow by the transmit end. Details are not described herein again.

Optionally, after obtaining (or perceiving) the block group flow through the MTN fg layer, the receive end may further perform CRC check on the block group flow. When the CRC check succeeds, the receive end may obtain payload information and/or overhead information in the block group flow. Optionally, when the CRC check fails, the receive end may also obtain the overhead information and the like in the block group flow.

It may be understood that the foregoing descriptions of the MTN fg layer are merely an example. In specific implementation, the MTN fg layer may have another name, another structure, or the like. This is not limited in this embodiment of this application.

It may be understood that the transmit end, the receive end, the intermediate node, and the like shown in embodiments of this application may also be collectively referred to as a communication apparatus. The communication apparatus may be a wired device, a wireless device (including a wireless terminal device, wireless user equipment, or the like), a switch, a router, a network adapter, a packet transport network (packet transport network, PTN), an agile transport network (agile transport network, ATN), a slicing packet network (slicing packet network, SPN), or the like. A specific form of the communication apparatus is not limited in this application. Optionally, a block group loss determining method provided in this application may be applied to a communication system including a transmit end and a receive end. Alternatively, in addition to the transmit end and the receive end, the communication system may further include an intermediate node located between the transmit end and the receive end.

A transmit end and a receive end are used as examples below to describe a block group loss determining method provided in an embodiment of this application. In the following embodiments, for example, the transmit end sends a block group at an MTN fg layer, and the receive end receives the block group at the MTN fg layer. It may be understood that for a block group, a first path, a receiving quantity, a target quantity, and the like that are mentioned below, refer to the foregoing descriptions. Details are not described below.

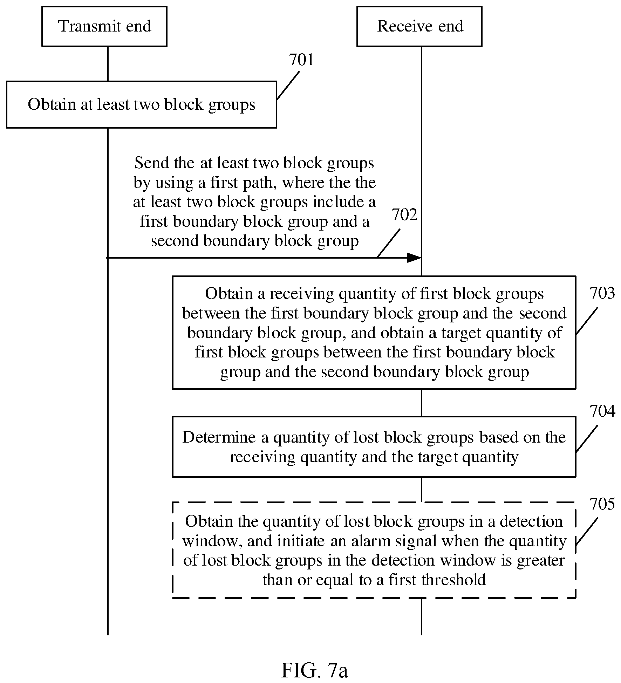

FIG. 7a is a schematic flowchart of a block group loss determining method according to an embodiment of this application. As shown in FIG. 7a, the method includes the following steps.

701: A transmit end obtains at least two block groups, where the at least two block groups include at least two boundary block groups, and the at least two boundary block groups include a first boundary block group and a second boundary block group.

Herein, that a transmit end obtains at least two block groups may be further understood as follows: The transmit end generates the at least two block groups. A format in which the transmit end encapsulates the block group may be shown in FIG. 4b or FIG. 4c. For how the transmit end encapsulates payload information, overhead information, and CRC information in the block group, refer to the foregoing descriptions. Details are not described herein again.

For example, that a transmit end obtains at least two block groups includes: The transmit end sequentially obtains the first boundary block group, a first block group, and the second boundary block group; or the transmit end sequentially obtains the first boundary block group, a first block group, the second boundary block group, the first block group, and a third boundary block group. Correspondingly, the transmit end may also send the at least two block groups in a shown sequence.

702: The transmit end sends the at least two block groups to a receive end by using a first path, and the receive end receives the at least two block groups by using the first path (as shown in FIG. 7a, the at least two block groups are transmitted by using the first path), where the at least two block groups include at least two boundary block groups, and the at least two boundary block groups include the first boundary block group and the second boundary block group.

A block group between the first boundary block group and the second boundary block group may be referred to as the first block group, and the first block group is included in the at least two block groups. Optionally, the at least two block groups may further include the third boundary block group or the like. Whether a quantity of first block groups between the first boundary block group and the second boundary block group is the same as a quantity of first block groups between the second boundary block group and the third boundary block group is not limited in this embodiment of this application. It may be understood that the first boundary block group, the second boundary block group, the third boundary block group, or the like shown in this embodiment of this application may be collectively referred to as a boundary block group.

Optionally, the at least two block groups received by the receive end may be block groups for which CRC information check succeeds. In other words, when the receive end receives the block group, the receive end may perform CRC check on the block group, and if the CRC check fails, the receive end may discard the block group. Optionally, if there is an intermediate node between the transmit end and the receive end, the intermediate node may also perform CRC check on a received block group, and if the CRC check fails, the intermediate node discards the block group. In this case, because a block group is lost, the receive end may determine a quantity of lost block groups based on the following step 703 and step 704. If the CRC check performed on the block group by the intermediate node, the receive end, or the like succeeds, the block group may be reserved.

Optionally, the transmit end may send the boundary block group in a preset periodicity. For example, the transmit end may send the boundary block group at a preset time interval. The preset time interval is used to measure duration in which the transmit end sends the block group. Therefore, a specific value of the preset time interval is not limited in this embodiment of this application. In addition, whether the preset time interval may be updated, how the preset time interval is updated, or the like is not limited in this embodiment of this application. For example, the transmit end may send the boundary block group every other minute. For example, the transmit end may alternatively send the boundary block group by using a preset quantity of block groups. For example, the transmit end may send the boundary block group every 100 first block groups. It may be understood that the preset quantity of block groups may be a quantity of first block groups, or may be a sum of a quantity of first block groups and a quantity of boundary block groups, or the like.

Optionally, when the transmit end sends the boundary block group in the preset periodicity, the receive end may further receive the boundary block group in the preset periodicity. It may be understood that for a specific implementation in which the transmit end sends the boundary block group and the first block group, further refer to the following embodiments.

703: The receive end obtains a receiving quantity of first block groups between the first boundary block group and the second boundary block group, and obtains a target quantity of first block groups between the first boundary block group and the second boundary block group.

In this embodiment of this application, the receiving quantity may be understood as the quantity of first block groups, a sum of the quantity of first block groups and a quantity of first boundary block groups, a sum of the quantity of first block groups and a quantity of second boundary block groups, or a sum of the quantity of first block groups, a quantity of first boundary block groups, and a quantity of second boundary block groups. It may be understood that the foregoing manner of understanding the receiving quantity is also applicable to a manner of understanding a sending quantity of block groups (referred to as a sending quantity for short below) sent by the transmit end in the following embodiments. In other words, understandings of the sending quantity and the receiving quantity in this embodiment of this application are consistent. If the sending quantity is the quantity of first block groups sent by the transmit end, the receiving quantity is a quantity of first block groups obtained by the receive end. If the sending quantity is a sum of the quantity of first block groups sent by the transmit end and the quantity of first boundary block groups (or second boundary block groups) sent by the transmit end, the receiving quantity is a sum of a quantity of first block groups obtained by the receive end and a quantity of first boundary block groups obtained by the receive end. If the sending quantity is a sum of the quantity of first block groups sent by the transmit end and a quantity of two boundary block groups (such as the first boundary block group and the second boundary block group) sent by the transmit end, the receiving quantity is a sum of a quantity of first block groups obtained by the receive end and a quantity of two boundary block groups obtained by the receive end.

For example, in a process in which the receive end receives the at least two block groups, for example, obtains overhead information of the block group at an MTN fg termination layer, the receive end distinguishes between the boundary block group and the first block group based on a difference between information included in the overhead information. The boundary block group herein may include two boundary block groups adjacent to the first block group, such as the first boundary block group and the second boundary block group. Specifically, a method for distinguishing between the boundary block group from the first block group by the receive end may be shown as follows:

In an implementation, the boundary block group includes first overhead information, and the first overhead information is used to identify the boundary block group. In this case, the receive end may identify the boundary block group and the first block group based on whether the at least two received block groups include the first overhead information.

Optionally, the first overhead information may be a flag bit, for example, the receive end may distinguish between the boundary block group and the first block group by using whether the block group includes the flag bit. For example, if the block group received by the receive end includes the flag bit, the block group is the boundary block group; and if the block group received by the receive end does not include the flag bit, the block group is the first block group.

Optionally, the boundary block group may further include fourth overhead information, and the fourth overhead information may be used to indicate the target quantity. In other words, the receive end may obtain the target quantity based on the fourth overhead information. If the fourth overhead information includes a first quantity, the receive end may obtain the target quantity based on the first quantity. If the fourth overhead information includes the first quantity and a second quantity, the receive end may obtain the target quantity based on the first quantity, the receive end may obtain the target quantity based on the second quantity, or the receive end may obtain the target quantity based on a sum of the first quantity and the second quantity. In other words, the first quantity can not only enable the receive end to obtain the target quantity, but can also enable the receive end to identify the boundary block group.

For example, the first overhead information and the fourth overhead information may be located at a same location (or referred to as a same field, different fields, or the like) in the block group. In this way, a case in which the first overhead information and the fourth overhead information excessively occupy bits of the block group and overhead information in the block group is reduced can be avoided. For example, the first overhead information and the fourth overhead information may alternatively be located at different locations (or referred to as different fields or the like) in the block group. In this case, the receive end may identify the boundary block group by using the flag bit, and then obtain the target quantity by using the first quantity and/or the second quantity included in the boundary block group. Therefore, the receive end can not only identify the boundary block group, but the receive end can also more accurately and more directly obtain the target quantity, so that accuracy of determining a quantity of lost block groups by the receive end is improved.

For example, when the transmit end sends the boundary block group in the preset periodicity, the receive end may further obtain the boundary block group in the preset periodicity. In addition, the receive end may distinguish between the boundary block group and the first block group by using whether the block group includes the sending quantity (such as the first quantity and/or the second quantity). In Embodiment 1 shown below, the receive end may obtain the boundary block group based on the preset periodicity and an offset window, and a size of the offset window is not limited in this embodiment of this application. In this case, if the receive end fails to obtain the boundary block group based on the preset periodicity and the offset window, it indicates that the boundary block group may have been lost in a current periodicity. Therefore, the receive end may obtain the boundary block group in a next periodicity based on the preset periodicity and the offset window.

It may be understood that a quantity of block groups (such as the first quantity) in the current periodicity may be included in a boundary block group in the current periodicity, or may be included in a boundary block group in a previous periodicity, or may be included in a boundary block group in a subsequent periodicity. This is not limited in this embodiment of this application.

In another implementation, the first block group includes second overhead information, and the second overhead information is used to identify the boundary block group. In this case, the receive end may identify the boundary block group and the first block group based on whether the at least two received block groups include the second overhead information. For specific descriptions of the second overhead information, correspondingly refer to the first overhead information. Details are not described herein again. Optionally, the first block group may further include fifth overhead information, and the fifth overhead information indicates the target quantity. For specific descriptions of the fifth overhead information, correspondingly refer to the fourth overhead information. Details are not described herein again.

In still another implementation, each of the at least two block groups includes third overhead information, and the third overhead information is used to identify the boundary block group. Third overhead information in two boundary block groups adjacent to the first block group is different from third overhead information in the first block group. Whether the third overhead information in the two boundary block groups adjacent to the first block group is the same is not limited in this embodiment of this application.

For example, the third overhead information may be a bit sequence. If bit sequences included in two adjacent block groups (for example, a $k^{th}$ block group and a $(k+1)^{th}$ block group) received by the receive end are different, the two adjacent block groups are separately the first block group and the boundary block group.

For example, the $k^{th}$ block group may be the boundary block group (such as the first boundary block group), and the $(k+1)^{th}$ block group may be the first block group. If bit sequences included in two adjacent block groups received by the receive end again are different, the two adjacent block groups are separately the first block group and the boundary block group. In this case, if the two adjacent block groups received by the receive end again are the $(k+1)^{th}$ block group and a $(k+2)^{th}$ block group, the $(k+2)^{th}$ block group is the boundary block group (such as the second boundary block group). If the two adjacent block groups received by the receive end again are a $(k+n1)^{th}$ block group and a $(k+n1+1)^{th}$ block group, the $(k+n1)^{th}$ block group is the first block group, and the $(k+n1+1)^{th}$ block group is the boundary block group (such as the second boundary block group). Therefore, first block groups obtained by the receive end may be the $(k+1)^{th}$ block group to the $(k+n1)^{th}$ block group. In other words, the receive end may distinguish between the first block group and the boundary block group by using a difference between third overhead information included in adjacent block groups. The third overhead information may be a bit sequence. For example, the bit sequence may be a 1-bit sequence, a 2-bit sequence, or a 3-bit sequence. A specific bit length of the bit sequence may be determined by a length of a fixed overhead location of the block group and/or a length of an expanded overhead location, or may be determined by a size of overhead that can be carried by the block group, or the like.

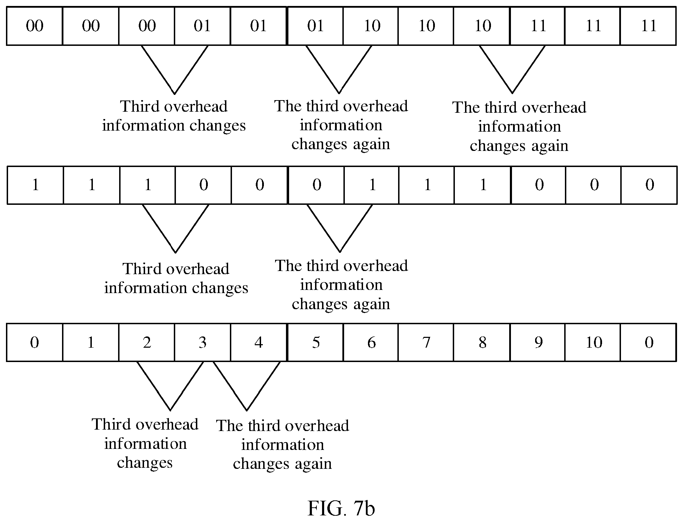

For example, the third overhead information is sequence number information, and therefore, the receive end may distinguish boundary block groups by using a difference between sequence number information of block groups. In a third figure in FIG. 7b, a number may be further understood as sequence number information of the block group.

A method for obtaining the receiving quantity by the receive end is: If the receive end receives the boundary block group, the receive end starts a block group loss counter, and if the receive end receives the boundary block group again, the receive end stops the block group loss counter, and obtains the receiving quantity based on the block group loss counter. For how the receive end identifies the boundary block group, refer to the specific descriptions above. For example, if the receive end detects that the third overhead information in the block group changes, the receive end starts the block group counter, and if the receive end detects again that the third overhead information in the block group changes, the receive end stops the block group counter. The receive end may obtain the receiving quantity based on the block group loss counter. For example, FIG. 7b shows three methods for distinguishing between the first block group and the boundary block group. In a first figure in FIG. 7b, for a block group 01, an adjacent block group 00 and an adjacent block group 10 are boundary block groups of the block group 01, and for the block group 10, an adjacent block group 01 and an adjacent block group 11 are boundary block groups of the block group 10. In a second figure in FIG. 7b, for a block group 0, an adjacent block group 1 is a boundary block group of the block group 0, and for the block group 1, the adjacent block group 0 is a boundary block group of the block group 1. In the third figure in FIG. 7b, for a block group 2, a block group 1 and a block group 3 are boundary block groups of the block group 2, and for the block group 3, the block group 2 and a block group 4 are boundary block groups of the block group 3. Alternatively, in the third figure in FIG. 7b, a block group 0 adjacent to a block group 1 and a block group 0 adjacent to a block group 10 may be boundary block groups of the block group 1 to the block group 10. It may be understood that numbers shown in FIG. 7b are merely examples, and should not be construed as a limitation on this embodiment of this application.

In an implementation, the target quantity may be included in the boundary block group. For example, the transmit end sends the boundary block group in the preset periodicity, and a quantity of first block groups in one periodicity may be included in a boundary block group (such as the second boundary block group) adjacent to the first block group, or is included in a boundary block group that is not adjacent to the first block group and that is located after the first block group.

In another implementation, the target quantity may alternatively be a preset quantity. In other words, the target quantity obtained by the receive end may be agreed on in advance, for example, set in a protocol or set through negotiation between the transmit end and the receive end.

In still another implementation, the target quantity may be determined by a difference between sequence number information of the first boundary block group and sequence number information of the second boundary block group. Alternatively, the target quantity may be determined based on sequence number information of the first boundary block group and sequence number information of the second boundary block group. For example, sequence number information of the block group is cycled from 0 to SEQmax-1. For this case, refer to the descriptions of the third figure in FIG. 7b.

It may be understood that for specific descriptions of the foregoing implementations, refer to the following descriptions.

704: The receive end determines a quantity of lost block groups based on the receiving quantity and the target quantity.

In other words, the receive end may obtain the quantity of lost block groups by comparing a quantity of obtained block groups and a quantity of block groups sent by the transmit end.

In a possible implementation, after the receive end determines the quantity of lost block groups based on the receiving quantity and the target quantity, the receive end may further obtain a quantity of lost block groups in a detection window. Further, the receive end may further determine a block group loss rate based on a quantity of received block groups in the detection window and the quantity of lost block groups in the detection window. In other words, Block group loss rate=Quantity of lost block groups in the detection window/Total quantity of block groups in the detection window. The total quantity of block groups described herein may include the quantity of first block groups, or may further include the quantity of boundary block groups. For example, if the sending quantity and the receiving quantity correspond to the quantity of first block groups, the total quantity of block groups may be a quantity of first block groups in the detection window. If the sending quantity and the receiving quantity correspond to a sum of the quantity of first block groups and the quantity of the two boundary block groups, the total quantity of block groups may be a sum of a quantity of first block groups and a quantity of boundary block groups in the detection window.

In this embodiment of this application, the block group loss counter may be disposed on the receive end, and therefore, the receive end may count the quantity of lost block groups by using the block group loss counter. After the receive end determines that a block group is lost, the receive end may trigger the block group loss counter to increase by 1, or a value added to the block group loss counter may be determined based on the quantity of lost block groups. In other words, each time the receive end performs step 704, if the quantity such as T of lost block groups is greater than or equal to 1, the receive end triggers the block group loss counter to increase by 1, or triggers the block group loss counter to increase by T.

In this embodiment of this application, a detection window counter may be further disposed on the receive end, and the detection window counter may be configured to count block groups received by the receive end in the detection window. The detection window may include at least two periodicities, but whether the detection window is an integer multiple of the periodicity is not limited in this embodiment of this application. For example, when check performed by the receive end on CRC information of a block group succeeds, the detection window counter increases by 1. When check performed by the receive end on CRC information of a block group fails, the detection window counter may not increase by 1. A length of the detection window is far greater than a length of one periodicity. Therefore, in this case, the receive end can still accurately obtain the block group loss rate. Alternatively, when check performed by the receive end on CRC information of a block group fails, the detection window counter increases by 1, and in addition, when check performed by the receive end on CRC information of a block group succeeds, the detection window counter increases by 1. Because the block group obtained by the receive end is a block group for which CRC information check succeeds, a lost block group may be a block group for which CRC information check fails, and therefore, in this case, the receive end can more accurately obtain the block group loss rate.

Optionally, when the detection window counter is reset, the block group loss counter may also be reset.

In this embodiment of this application, the receive end may further determine a line bit error rate based on the quantity of lost block groups in the detection window and the total quantity of block groups in the detection window.

Because the block group shown in this embodiment of this application is a fixed length, a one-to-one correspondence may be established between the block group loss rate and the line bit error rate; in other words, the line bit error rate may be obtained by using the block group loss rate. For a relationship between the block group loss rate and the line bit error rate, refer to related descriptions in Table 1 and Table 2. It may be understood that the line bit error rate shown in this embodiment of this application may also be referred to as a bit error rate of a fine-grained path or a bit error rate of the first path. A name of the line bit error rate is not limited in this embodiment of this application.

705: Initiate an alarm signal when the quantity of lost block groups in the detection window is greater than or equal to a first threshold.

Alternatively, step 705 may alternatively be replaced with: Eliminate an alarm signal when the quantity of lost block groups in the detection window is less than or equal to a second threshold.

For example, if a value of the block group loss counter is greater than or equal to the first threshold (such as 20), the receive end may generate the alarm signal. In this case, the detection window counter continues counting, and the block group loss counter is reset after the detection window ends (in other words, the detection window counter reaches a window threshold). Optionally, if the block group loss counter still does not exceed the first threshold when the detection window counter reaches the window threshold, the block group loss counter is still reset, but does not generate the alarm signal.

For example, when there is the alarm signal, if the block group loss counter is greater than or equal to the second threshold (such as 0 or 1), the alarm cannot be eliminated. The detection window counter continues to perform counting until the detection window ends, the block group loss counter continues counting, and the block group loss counter is reset when the window ends. Optionally, if the block group loss counter is less than the second threshold when the detection window counter reaches the window threshold, the block group loss counter is reset to eliminate the alarm signal.

For example, the alarm signal may include signal degrade (signal degrade) or signal failure (signal failure).

In this embodiment of this application, the block group is encapsulated by using the fixed length, and therefore the relationship between the line bit error rate and the block group loss rate is no longer random, but is determined. For example, the following condition may be met by the block group loss rate and the line bit error rate: $Prb_{dropblockgroup} = 1 - P(0$ $error\ in\ blockgroup) = 1 - (1 - BER)^{blockgroupLength}$

$Prb_{dropblockgroup}$ represents the block group loss rate, $P(0\ error\ in\ block\ group)$ represents a probability that all bits in a block group are correct, $BER$ represents the line bit error rate, and $blockgroupLength$ represents a block group length. Table 1 may be obtained based on the relationship between the block group loss rate and the line bit error rate.

Based on a central limit theorem, when bit errors are in normal distribution, the following formula may be obtained, that is, a quantity of detected bits that enable the detected line bit error rate to have a confidence level (confidence level, CL).

$$n = \frac{1}{BER}[-\ln(1-CL) + \ln(\sum_{k=0}^{E} \frac{(n*BER)^k}{k!})].$$

n represents a quantity of bits detected by the receive end, CL represents a confidence level of the line bit error rate, BER represents the line bit error rate, and E represents the second threshold. The foregoing formula indicates a quantity of block groups (that is, a quantity of block groups included in the detection window) that need to be received by the receive end on the basis of a specific confidence level and the line bit error rate when the alarm signal is eliminated. In other words, a relationship between the line bit error rate and the quantity of block groups in the detection window shown in Table 2 may be obtained by using the foregoing formula.

When the second threshold E is equal to 0, that is, no bit error is detected, the foregoing formula may be simplified as follows:

$$n = \frac{1}{BER}[-\ln(1-CL) + \ln(1)].$$

Therefore, the quantity of bits that need to be detected when the alarm signal is eliminated, that is, the quantity of block groups that need to be detected, may be obtained by using the foregoing formula.

Table 1 and Table 2 show a relationship between the line bit error rate and the detection window when the block group length is 192 bytes.

**Table 1**

| Block group length | Block group detection window (quantity of block groups) | Block group discard detection threshold (quantity of block groups) | Required detection time (s) | | Block group loss rate corresponding to a line bit error rate | Alarm generation threshold/Line bit error rate |
|---|---|---|---|---|---|---|
| | | | Minimum slot 2.5 Mbps | Minimum slot 10 Mbps | | |
| 192 B | $1\times10^2$ | 20 | $6.14\times10^{-2}$ | $1.536\times10^{-2}$ | $1.423\times10^{-1}$ | $1\times10^{-4}$ |
| | $1\times10^3$ | 20 | $6.14\times10^{-1}$ | $1.536\times10^{-1}$ | $1.53\times10^{-2}$ | $1\times10^{-5}$ |
| | $1\times10^4$ | 20 | 6.14 | 1.536 | $1.53\times10^{-3}$ | $1\times10^{-6}$ |
| | $1\times10^5$ | 20 | $6.14\times10^1$ | $1.536\times10^1$ | $1.53\times10^{-4}$ | $1\times10^{-7}$ |
| | $1\times10^6$ | 20 | $6.14\times10^2$ | $1.536\times10^2$ | $1.53\times10^{-5}$ | $1\times10^{-8}$ |
| | $1\times10^7$ | 20 | $6.14\times10^3$ | $1.536\times10^3$ | $1.53\times10^{-6}$ | $1\times10^{-9}$ |
| | $1\times10^8$ | 20 | $6.14\times10^4$ | $1.536\times10^4$ | $1.53\times10^{-7}$ | $1\times10^{-10}$ |
| | $1\times10^9$ | 20 | $6.14\times10^5$ | $1.536\times10^5$ | $1.53\times10^{-8}$ | $1\times10^{-11}$ |
| | $1\times10^{10}$ | 20 | $6.14\times10^6$ | $1.536\times10^6$ | $1.53\times10^{-9}$ | $1\times10^{-12}$ |

A quantity of block groups in the detection window that are required for generating the alarm signal and the corresponding alarm generation threshold are shown in Table 1. For example, when the alarm generation threshold is set to BER≥$10^{-6}$, the detection window may include $10^4$ block groups. Once 20 block groups or more than 20 block groups are lost in the detection window, the line bit error rate is lower than $10^{-6}$, and the receive end generates the alarm signal.

The quantity of block groups in the detection window and a corresponding alarm elimination threshold are shown in Table 2. For example, if the alarm elimination threshold is BER≤($1\times10^{-6}$), the detection window may include $2\times10^3$ block groups. When it is detected that no block group is lost in continuously received $2\times10^3$ block groups, the line BER≤($1\times10^{-6}$), and the receive end eliminates the alarm signal.

**Table 2**

| Block group length | Block group zero-loss detection window (quantity of block groups) | Block group zero-loss detection window (s) | | Alarm elimination threshold/Line bit error rate |
|---|---|---|---|---|
| | | Minimum slot 2.5 Mbps | Minimum slot 10 Mbps | |
| 192 B | $2\times10^1$ | $1.2\times10^{-2}$ | $3\times10^{-3}$ | $1\times10^{-4}$ |
| | $2\times10^2$ | $1.2\times10^{-1}$ | $3\times10^{-2}$ | $1\times10^{-5}$ |
| | $2\times10^3$ | $1.2$ | $3\times10^{-1}$ | $1\times10^{-6}$ |
| | $2\times10^4$ | $1.2\times10^1$ | $3$ | $1\times10^{-7}$ |
| | $2\times10^5$ | $1.2\times10^2$ | $3\times10^1$ | $1\times10^{-8}$ |
| | $2\times10^6$ | $1.2\times10^3$ | $3\times10^2$ | $1\times10^{-9}$ |
| | $2\times10^7$ | $1.2\times10^4$ | $3\times10^3$ | $1\times10^{-10}$ |
| | $2\times10^8$ | $1.2\times10^5$ | $3\times10^4$ | $1\times10^{-11}$ |
| | $2\times10^9$ | $1.2\times10^6$ | $3\times10^5$ | $1\times10^{-12}$ |

It may be learned from Table 1 and Table 2 that the receive end may determine, by using the quantity of block groups in the detection window and the quantity of lost block groups, whether the alarm signal is generated or the alarm signal is eliminated. The correspondence between the line bit error rate and the block group loss rate is established, so that the receive end can monitor the line bit error rate by monitoring the block group loss rate. It may be understood that the block group length in Table 1 and Table 2 is a length of a data block in the block group.

In this embodiment of this application, the receive end can not only identify the boundary block group, but also obtain a quantity of first block groups between two boundary block groups, to obtain the receiving quantity. Through comparison between the target quantity and the receiving quantity, the quantity of lost block groups and a line bit error status of the first path such as a bit error rate of the first path can be obtained.

For vivid understanding of the method shown in FIG. 7a, specific embodiments of the block group loss determining method are provided below.

**Embodiment 1**

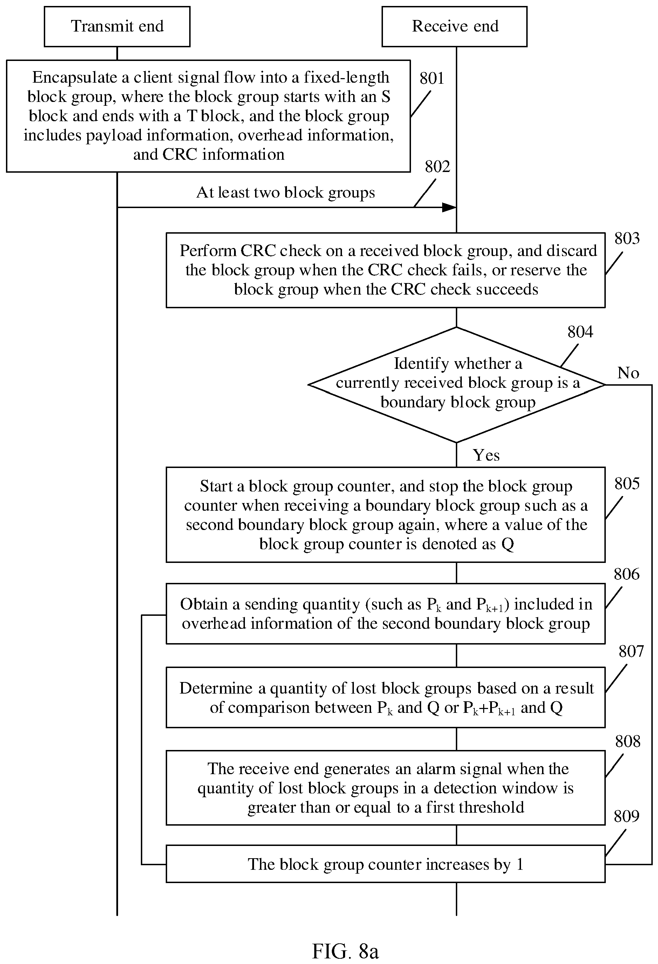

FIG. 8a is a schematic flowchart of a block group loss determining method according to an embodiment of this application. The method is shown by using an example in which a boundary block group includes first overhead information and fourth overhead information, but this should not be construed as a limitation on this embodiment of this application. As shown in FIG. 8a, the method includes the following steps.

801: A transmit end encapsulates a client signal flow into a fixed-length block group, where the block group starts with an S block and ends with a T block, and the block group includes payload information, overhead information, and CRC information.

802: The transmit end sends at least two block groups to a receive end, and the receive end receives the at least two block groups. Herein, a quantity of block groups sent by the transmit end is not necessarily the same as a quantity of block groups received by the receive end. The transmit end may alternatively send the at least two block groups to the receive end by using a first path, and the receive end receives the at least two block groups by using the first path.

To enable the receive end to clearly learn the quantity of block groups sent by the transmit end, the transmit end may insert a sending quantity of block groups sent by the transmit end into overhead information in some block groups. For ease of distinguishing, in FIG. 8a, a block group into which the sending quantity (that is, fourth overhead information) and a flag bit (that is, first overhead information) are inserted is referred to as a boundary block group, and a block group into which the sending quantity is not inserted is referred to as a first block group.

In this embodiment of this application, the transmit end may send the boundary block group in a preset periodicity, for example, send the boundary block group at a preset time interval or by using a preset quantity of block groups. For example, the transmit end sends the boundary block group in the preset periodicity. Therefore, when generating the block group at an MTN fg adaptation layer, the transmit end may insert the flag bit into overhead information in the block group, and then insert the sending quantity at an MTN fg termination layer. Alternatively, the transmit end may insert the flag bit, the sending quantity, and the like at the MTN fg termination layer. When the transmit end inserts the flag bit and the sending quantity is not limited in this embodiment of this application. For example, a quantity of block groups sent by the transmit end in each periodicity may be agreed on in advance. Whether a quantity of block groups sent in each periodicity is the same is not limited in this embodiment of this application. In this case, the quantity of block groups sent in each periodicity may be included in any one or more boundary block groups. This is not limited in this embodiment of this application.

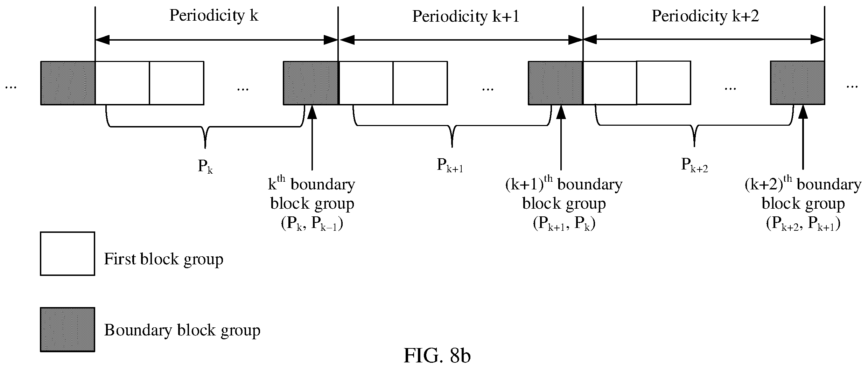

For example, as shown in FIG. 8b, when sending a $k^{th}$ boundary block group, the transmit end starts a block group sending counter. Each time the transmit end sends one first block group, the block group sending counter increases by 1, and the transmit end stops the block group sending counter when the transmit end sends a $(k+1)^{th}$ boundary block group. In this case, the transmit end inserts a value of the block group sending counter such as $P_{k+1}$ (that is, the fourth overhead information) into overhead information in the $(k+1)^{th}$ boundary block group. Alternatively, $P_{k+1}$ may be inserted into overhead information in a $(k+2)^{th}$ boundary block group. This is not limited in this embodiment of this application. In a method in which the transmit end counts sent block groups by using the block group sending counter, a value of $P_{k+1}$ can be more accurate.

The method provided in this embodiment of this application is described below by using an example in which $P_{k+1}$ is inserted into the overhead information in the $(k+1)^{th}$ boundary block group.

It may be understood that each time the transmit end sends one boundary block group, the block group sending counter may be reset to 0.

Optionally, the sending quantity may be a quantity of first block groups in one periodicity, or the sending quantity may be a quantity of first block groups in each periodicity in adjacent periodicities. For example, as shown in FIG. 8b, a sending quantity in the overhead information in the $(k+2)^{th}$ boundary block group may be $P_{k+2}$, or $P_{k+2}$ and $P_{k+1}$, or $P_k$, $P_{k+1}$, and $P_{k+2}$. It may be understood that a quantity of first block groups in a specific quantity of periodicities included in the boundary block group is not limited in this embodiment of this application. This embodiment of this application is described below by using an example in which a sending quantity in overhead information in one boundary block group is a quantity of first block groups in either of two periodicities.

It may be understood that a quantity of first block groups inserted into the overhead information in the boundary block group is shown herein as an example. However, in this embodiment of this application, a sum of a quantity of first block groups and a quantity of boundary block groups may alternatively be inserted into the overhead information in the boundary block group. For example, $P_{k+1}$ or $P_{k+2}$ may be further inserted into the overhead information in the $k^{th}$ boundary block group.

803: The receive end performs CRC check on the received block group, and discards the block group when the CRC check fails, or reserves the block group when the CRC check succeeds.

It may be understood that the receive end may perform CRC check on each of the received at least two block groups.

804: The receive end identifies whether a currently received block group is the boundary block group such as a first boundary block group, and performs step 805 to step 808 if the currently received block group is the boundary block group, or performs step 809 if the currently received block group is not the boundary block group.

In this embodiment of this application, if overhead information in the currently received block group includes the flag bit, the currently received block group is the boundary block group such as the first boundary block group. Alternatively, if the overhead information in the currently received block group includes the sending quantity, the currently received block group is the boundary block group such as the first boundary block group.

805: The receive end starts a block group counter, and stops the block group counter when receiving the boundary block group such as a second boundary block group again, where a value of the block group counter is denoted as Q.

The block group counter may be configured to count a quantity of first block groups between two boundary block groups. For a method for identifying the boundary block group by the receive end, refer to the descriptions in step 804, or refer to the descriptions in FIG. 7a. Details are not described herein again.

It may be understood that the receive end may simultaneously perform step 803 to step 805; or the receive end may perform step 803 and step 804, and then start the block group counter; or the like. This is not limited in this embodiment of this application.

806: The receive end obtains a target quantity based on a sending quantity (such as $P_k$ and $P_{k+1}$) included in overhead information in the second boundary block group.

For example, the target quantity may be $P_k+P_{k+1}$. $P_k$ may be understood as a first quantity, and $P_{k+1}$ may be understood as a second quantity.

For example, if the current block group received by the receive end in step 804 is a $(k-1)^{th}$ boundary block group (such as the first boundary block group), the $k^{th}$ boundary block group is the second boundary block group. Alternatively, if the $k^{th}$ boundary block group has been lost, the $(k+1)^{th}$ boundary block group is the second boundary block group.

807: The receive end determines a quantity of lost block groups based on a result of comparison between $P_k$ and Q or $P_k+P_{k+1}$ and Q.

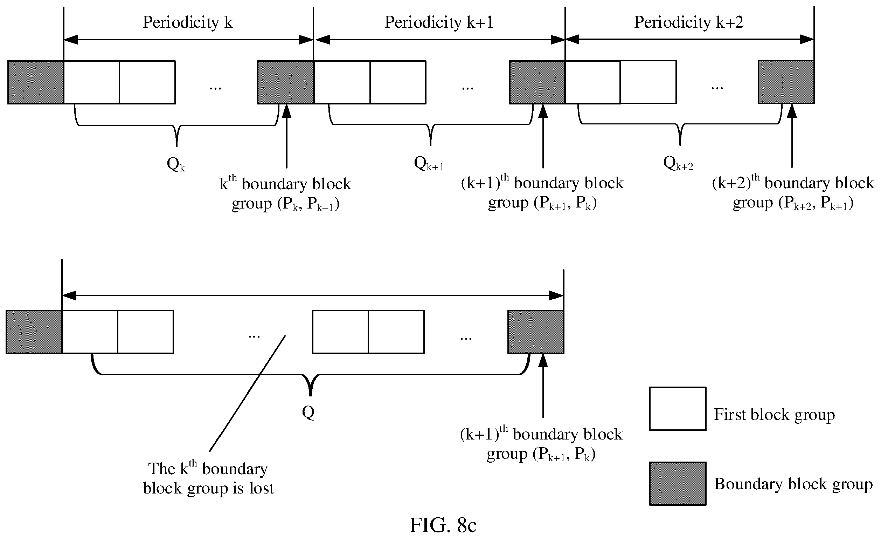

As shown in FIG. 8c, if $(P_k-Q) \geq 0$, it indicates that the $k^{th}$ boundary block group is not discarded, a quantity of lost first block groups between the first boundary block group and the second boundary block group is $(P_k-Q)$, and a block group loss counter increases by $(P_k-Q)$. If $(P_k-Q)<0$, it indicates that the $k^{th}$ boundary block group is discarded, the quantity of lost first block groups between the first boundary block group and the second boundary block group is ($P_k$+$P_{k+1}$-Q), and the block group loss counter increases by ($P_k$+$P_{k+1}$-Q). It may be understood that, that the block group loss counter increases by ($P_k$-Q) in this embodiment of this application may alternatively be represented as follows: The block group loss counter increases by ($P_k$-Q), a value of the block group loss counter value increases by ($P_k$-Q), or the like. For this description, another similar expression in this embodiment of this application is also applicable.

If ($P_k$-Q)<0, it indicates that at least one boundary block group is lost in a block group transmission process. In this way, the transmit end can enable, by including a quantity of block groups in either of two adjacent periodicities, the receive end to resist a case in which one boundary block group is lost.

Optionally, the receive end may alternatively determine the quantity of lost block groups based on a result of comparison between $P_{k-1}$ and Q. In other words, in an implementation, the receive end may compare the receiving quantity with any one (or more) of a plurality of sending quantities included in the boundary block group. In another implementation, when inserting a plurality of sending quantities into the boundary block group, the transmit end may further insert a sending quantity in a corresponding periodicity at a corresponding location based on a correspondence between a location and a periodicity. FIG. 4b is used as an example. The transmit end may insert a quantity (such as $P_k$) of block groups in a current periodicity into OAM_value1 of a first data block, and insert a quantity (such as $P_{k-1}$) of block groups in a previous periodicity into OAM_value2 of a second data block. Therefore, when receiving the boundary block group, the receive end can accurately learn the quantity of block groups in the current periodicity and the quantity of block groups in the previous periodicity.

808: The receive end generates an alarm signal when a quantity of lost block groups in a detection window is greater than or equal to a first threshold. When the quantity of lost block groups in the detection window is greater than or equal to the first threshold, it indicates that a block group loss rate is greater than or equal to an alarm generation threshold, and in addition, it may also indicate that a line bit error rate is greater than or equal to the alarm generation threshold.

Alternatively, step 808 may alternatively be replaced with: Eliminate an alarm signal when a quantity of lost block groups in a detection window is less than or equal to a second threshold (such as 1 or 0). When the quantity of lost block groups in the detection window is less than or equal to the second threshold, it indicates that a block group loss rate is less than or equal to an alarm elimination threshold, and in addition, it may also indicate that a line bit error rate is less than or equal to the alarm elimination threshold.

It may be understood that for specific descriptions of step 808, refer to FIG. 7a. Details are not described herein again.

809: The block group counter increases by 1.

**Embodiment 2**

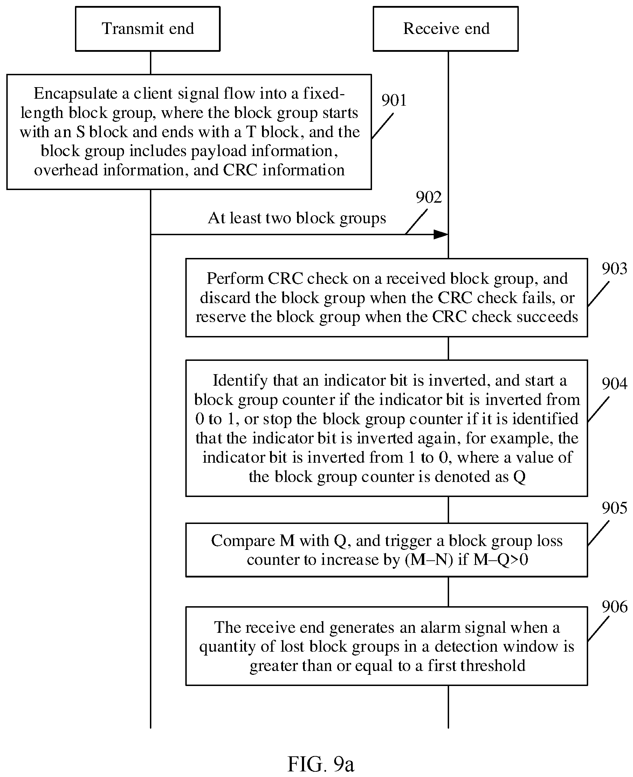

FIG. 9a is a schematic flowchart of a block group loss determining method according to an embodiment of this application. The method is shown by using an example in which a block group includes third overhead information and the third overhead information is a 1-bit bit sequence, but this should not be construed as a limitation on this embodiment of this application. As shown in FIG. 9a, the method includes the following steps.

It may be understood that for step 901 to step 903, refer to step 801 to step 803.

In this embodiment of this application, the transmit end may send the block group by using a preset quantity of block groups. In other words, a sending quantity may be a preset quantity; in other words, a quantity of block groups in each periodicity may be a fixed value.

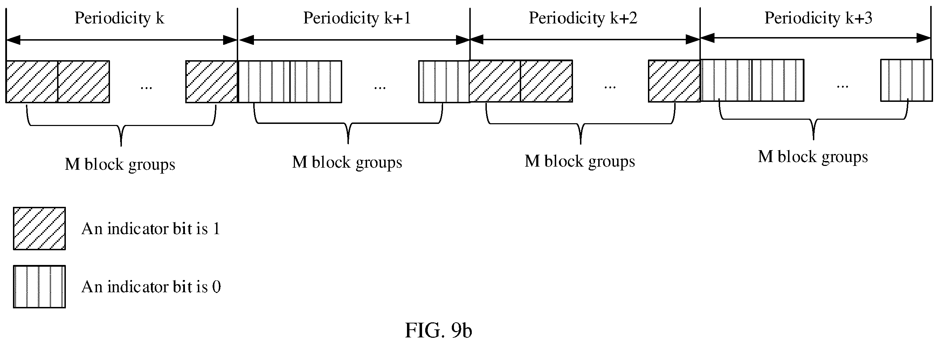

In this embodiment of this application, the transmit end may insert a bit sequence (such as the third overhead information) into overhead information in the block group, so that the receive end may distinguish between a boundary block group and a first block group based on a difference between bit sequences. For example, the overhead information in the block group may include an indicator bit 1 (that is, a bit sequence 1) or an indicator bit 0 (that is, a bit sequence 0). For example, overhead information in block groups in a same periodicity may include a same indicator bit; in other words, the indicator bit may be periodically inverted. As shown in FIG. 9b, when sending a first block group in a periodicity k, the transmit end starts a block group sending counter. Each time the transmit end sends one block group, the block group sending counter increases by 1, and the transmit end stops the block group sending counter when the transmit end sends M block groups. In addition, when the transmit end sends the block group, the indicator bit 1 is inserted into overhead information in the block group. Then, the block group sending counter may be reset to 0, the transmit end counts block groups in a periodicity k+1, and inserts the indicator bit 0 into overhead information in the block group in the periodicity k+1.

904: The receive end identifies that the indicator bit is inverted, and starts a block group counter if the indicator bit is inverted from 0 to 1, or stops the block group counter if it is identified that the indicator bit is inverted again, for example, the indicator bit is inverted from 1 to 0, where a value of the block group counter is denoted as Q.

905: The receive end compares M with Q, and triggers a block group loss counter to increase by (M-N) if M-Q>0.

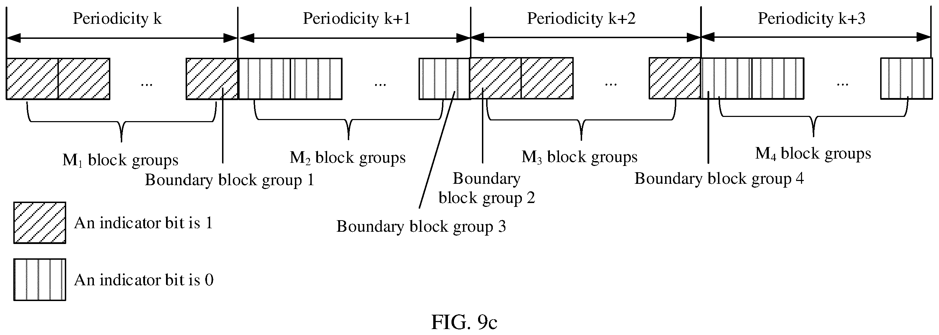

As shown in FIG. 9c, if the receive end identifies that the indicator bit is inverted from 1 to 0, the block group counter is started, and if it is identified that the indicator bit is inverted from 0 to 1, the block group counter is stopped. A value of the block group counter is denoted as $M_2$. Based on a same method, the receive end may separately obtain values of the block group counter, such as $M_1$, $M_2$, $M_3$, and $M_4$. Therefore, the receive end may separately compare M with $M_1$, M with $M_2$, M with $M_3$, and M with $M_4$ to obtain a quantity of lost block groups.

In this case, the boundary block group may be shown in FIG. 9c. For the block group in the periodicity k+1, a boundary block group 1 and a boundary block group 2 may be respectively understood as a first boundary block group and a second boundary block group, and the block group in the periodicity k+1 is the first block group. For a block group in a periodicity k+2, a boundary block group 3 and a boundary block group 4 may be respectively understood as the first boundary block group and the second boundary block group, and the block group in the periodicity k+2 is the first block group.

It may be understood that, for step 906, refer to step 808.

In this embodiment of this application, the indicator bit is 1 bit. The 1-bit indicator bit is used, so that not only the receive end identifies the boundary block group, but also overheads of the block group can be reduced.

**Embodiment 3**

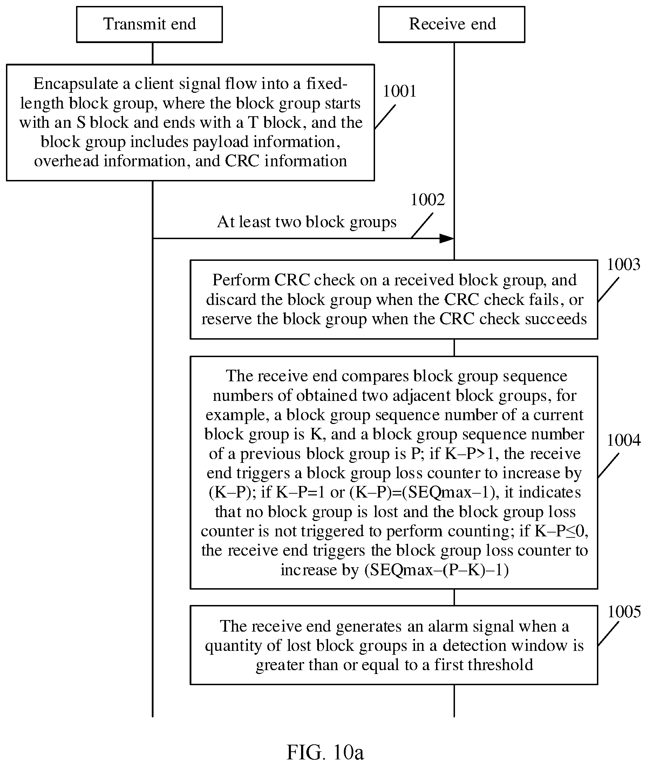

FIG. 10a is a schematic flowchart of a block group loss determining method according to an embodiment of this application. The method is shown by using an example in which a boundary block group includes third overhead information and the third overhead information is sequence number information (which is referred to as a block group sequence number below), but this should not be construed as a limitation on this embodiment of this application. As shown in FIG. 10a, the method includes the following steps.

It may be understood that for step 1001 to step 1003, refer to step 801 to step 803.

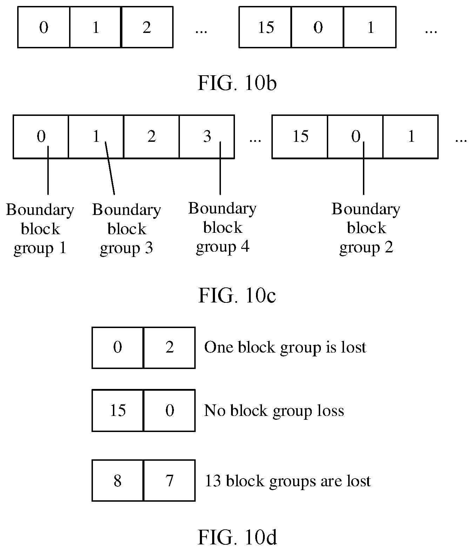

In this embodiment of this application, overhead information in the block group may include a block group sequence number (such as the third overhead information). For example, the block group sequence number may be cycled from 0 to (SEQmax-1). For example, if a block group sequence number of a previous block group sent by the transmit end is 0, a block group sequence number of a current block group is 1, and a block group sequence number of a next block group is 2. For another example, if a sequence number of a current block group sent by the transmit end is (SEQmax-1), a block group sequence number of a next block group is 0. As shown in FIG. 10b, a block group sequence number may be cycled from 0 to 15.

1004: The receive end compares block group sequence numbers of obtained two adjacent block groups, for example, a block group sequence number of a current block group is K, and a block group sequence number of a previous block group is P. If K-P>1, the receive end triggers a block group loss counter to increase by (K-P). If K-P=1 or (K-P)= (SEQmax-1), it indicates that no block group is lost and the block group loss counter is not triggered to perform counting. If K-P≤0, the receive end triggers the block group loss counter to increase by (SEQmax-(P-K)-1).

For example, step 1004 may alternatively be replaced with: The receive end identifies that sequence numbers of two adjacent block groups change, for example, a block group sequence number of a previous block group is K1, and a block group sequence number of a current block group is K2; and if the receive end identifies again that sequence numbers of two adjacent block groups change, for example, the block group sequence number of the previous block group is K2, and the block group sequence number of the current block group is K3, if K3-K1>2, the receive end triggers a block group loss counter to increase by (K3-K1); if K3-K1=2 or K3-K1=(SEQmax-2), it indicates that no block group is lost and the block group loss counter is not triggered to perform counting; and if K3-K1≤0, the receive end triggers the block group loss counter to increase by (SEQmax-(P-K)-2). It may be understood that the foregoing method for obtaining a quantity of lost block groups by the receive end based on the block group sequence number is merely an example.

As shown in FIG. 10c, for a block group 2, a block group 1 and a block group 3 may be understood as boundary block groups, for example, are a boundary block group 3 and a boundary block group 4 respectively. For the block group 1 to a block group 15, two adjacent block groups 0 may be boundary block groups, for example, are a boundary block group 1 and a boundary block group 2 respectively. Whether the receive end specifically determines the quantity of lost block groups in a unit of one block group (or a plurality of block groups) or determines the quantity of lost block groups in a unit of SEQmax is not limited in this embodiment of this application.

As shown in FIG. 10d, if sequence numbers of two adjacent block groups obtained by the receive end are 0 and 2, the block group loss counter is triggered to increase by 1. If the sequence numbers of the two adjacent block groups obtained by the receive end are 15 and 0, it indicates that no block group is lost. If the sequence numbers of the two adjacent block groups obtained by the receive end are 8 and 7, the block group loss counter is triggered to increase by 13.

It may be understood that numbers shown above are merely examples, and should not be construed as a limitation on this embodiment of this application.

It may be understood that, for step 1005, refer to step 808.

In the foregoing three embodiments, for example, as shown in FIG. 4b, the flag bit may be carried at a location SEQ in a second row (that is, a first data block), the indicator bit may be carried at a reserved location in the second row, and the block group sequence number may be carried at an OAM_value1 location in the second row, an OAM_value2 location in a third row (that is, a second data block), or the like.

It may be understood that two boundary block groups are as an example in the foregoing embodiments. However, the foregoing embodiments may be further applied to a larger quantity of boundary block groups and first block groups. Details are not described herein.

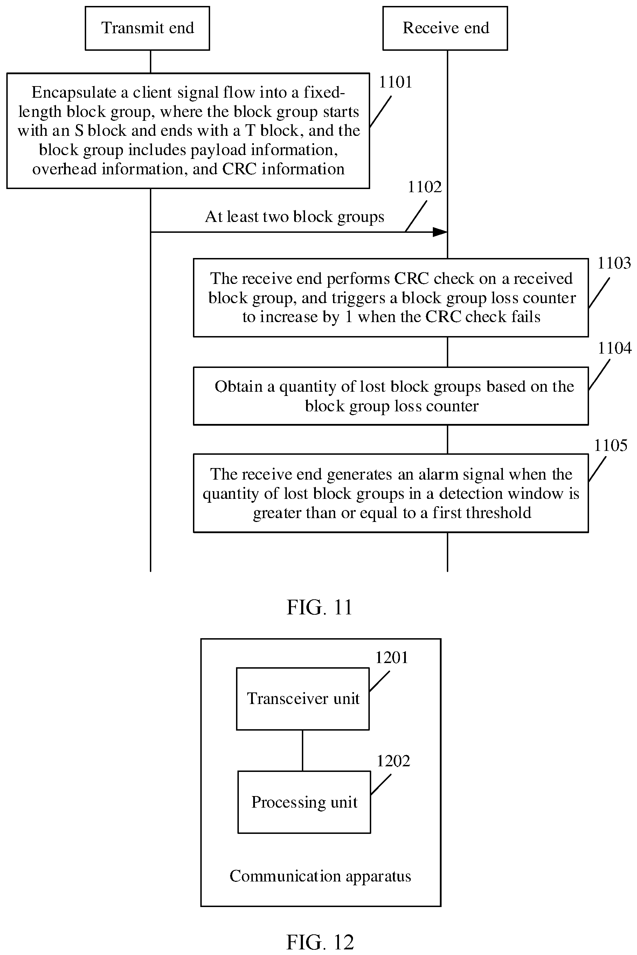

It may be understood that the foregoing embodiments are shown by using a case in which CRC information check performed by the receive end on the block group fails and the block group is discarded. An embodiment of this application further provides a method. The method is shown by using a case in which CRC information check performed by the receive end on the block group succeeds and the block group is not discarded. As shown in FIG. 11, the method includes the following steps.

1101: A transmit end encapsulates a client signal flow into a fixed-length block group, where the block group starts with an S block and ends with a T block, and the block group includes payload information, overhead information, and CRC information.

1102: The transmit end sends at least two block groups to a receive end, and the receive end receives the at least two block groups.

1103: The receive end performs CRC check on the received block group, and triggers a block group loss counter to increase by 1 when the CRC check fails.

In other words, the receive end may check CRC information of each received block group, and triggers the block group loss counter to increase by 1 when the CRC information check fails.

1104: The receive end obtains a quantity of lost block groups based on the block group loss counter.

In other words, the receive end may determine the quantity of lost block groups based on a quantity of block groups for which CRC check fails. For example, the receive end may determine a quantity of lost block groups in a detection window based on the quantity of block groups for which CRC check fails.

1105: The receive end generates an alarm signal when a quantity of lost block groups in a detection window is greater than or equal to a first threshold. When the quantity of lost block groups in the detection window is greater than or equal to the first threshold, it indicates that a block group loss rate is greater than or equal to an alarm generation threshold, and in addition, it may also indicate that a line bit error rate is greater than or equal to the alarm generation threshold.

It may be understood that each of the foregoing embodiments has a focus. For an implementation that is not described in detail in one embodiment, refer to another embodiment. Details are not described herein again. Further, the embodiments described in this specification may be independent solutions, or may be combined based on internal logic. These solutions fall within the protection scope of this application.

It should be understood that sequence numbers of the foregoing processes do not mean execution sequences in embodiments of this application. The execution sequences of the processes should be determined based on functions and internal logic of the processes, and should not constitute any limitation on implementation processes of embodiments of this application.

A communication apparatus provided in embodiments of this application is described below.

FIG. 12 is a schematic diagram of a structure of a communication apparatus according to an embodiment of this application. The communication apparatus may be configured to perform the method shown in FIG. 7a, FIG. 8a, FIG. 9a, FIG. 10a, or FIG. 11 in the foregoing embodiments. As shown in FIG. 12, the communication apparatus includes a transceiver unit 1201 and a processing unit 1202.

The transceiver unit 1201 is configured to receive at least two block groups, where the at least two block groups include at least two boundary block groups, and the at least two boundary block groups include a first boundary block group and a second boundary block group.

The processing unit 1202 is configured to: obtain a receiving quantity of first block groups between the first boundary block group and the second boundary block group, where the first block group is included in the at least two block groups; obtain a target quantity of first block groups between the first boundary block group and the second boundary block group; and determine a quantity of lost block groups based on the receiving quantity and the target quantity.

In a possible implementation, the processing unit 1202 is specifically configured to: when the receiving quantity is greater than a first quantity or the receiving quantity is greater than a second quantity, determine the quantity of lost block groups based on a sum (that is, the target quantity) of the receiving quantity, the first quantity, and the second quantity.

In a possible implementation, the processing unit 1202 is specifically configured to determine the target quantity by using a difference between third overhead information in the first boundary block group and third overhead information in the second boundary block group.

In a possible implementation, the transceiver unit 1201 is specifically configured to receive the at least two block groups by using a first path.

In a possible implementation, the processing unit 1202 is further configured to determine a line bit error rate based on a quantity of lost block groups in a detection window.

In a possible implementation, the processing unit 1202 is further configured to: obtain the quantity of lost block groups in the detection window; and initiate an alarm signal when the quantity of lost block groups in the detection window is greater than or equal to a first threshold; or eliminate the alarm signal when the quantity of lost block groups in the detection window is less than or equal to a second threshold.

It may be understood that for descriptions of the first boundary block group, the second boundary block group, the first block group, the receiving quantity, the target quantity, the first path, a second path, first overhead information, second overhead information, the third overhead information, fourth overhead information, fifth overhead information, and the like, refer to the foregoing embodiments. Details are not described herein again.

For example, the processing unit 1202 may be further configured to perform step 803 to step 808 or step 809 in FIG. 8a. Alternatively, the processing unit 1202 may be further configured to perform step 903 to step 906 in FIG. 9a. Alternatively, the processing unit 1202 may be further configured to perform step 1003 to step 1005 in FIG. 10a. Alternatively, the processing unit 1202 may be further configured to perform step 1103 to step 1105 in FIG. 11. For example, the processing unit 1202 may be configured to invoke the transceiver unit 1201 to perform a receiving and/or sending function.

For specific implementations of the processing unit 1202 and the transceiver unit 1201, refer to the foregoing embodiments and the like. Details are not described herein again.

As shown in the foregoing embodiment, the communication apparatus is shown as the receive end in the foregoing embodiments. It may be understood that the communication apparatus shown in FIG. 12 may alternatively be used as the transmit end in the foregoing embodiments. For example, the processing unit 1202 may be further configured to obtain at least two block groups, and the transceiver unit 1201 may be further configured to send the at least two block groups. For a specific implementation in which the communication apparatus is used as the transmit end, refer to steps performed by the transmit end in the method shown in FIG. 7a, FIG. 8a, FIG. 9a, FIG. 10a, or FIG. 11.

It should be understood that when the communication apparatus shown in FIG. 12 is a communication apparatus or a component that implements the foregoing functions in the communication apparatus, and the processing unit 1202 may be one or more processors, the transceiver unit 1201 may be a transceiver; or the transceiver unit 1201 may be a sending unit and a receiving unit, the sending unit may be a transmitter, the receiving unit may be a receiver, and the sending unit and the receiving unit are integrated into one component such as a transceiver.

When the communication apparatus is a circuit system such as a chip system, the processing unit 1202 may be one or more processing circuits or the like, and the transceiver unit 1201 may be an input/output interface that may alternatively be referred to as a communication interface, an interface circuit, an interface, or the like. Alternatively, the transceiver unit 1201 may alternatively be a sending unit and a receiving unit, the sending unit may be an output interface, the receiving unit may be an input interface, and the sending unit and the receiving unit are integrated into one unit such as an input/output interface.

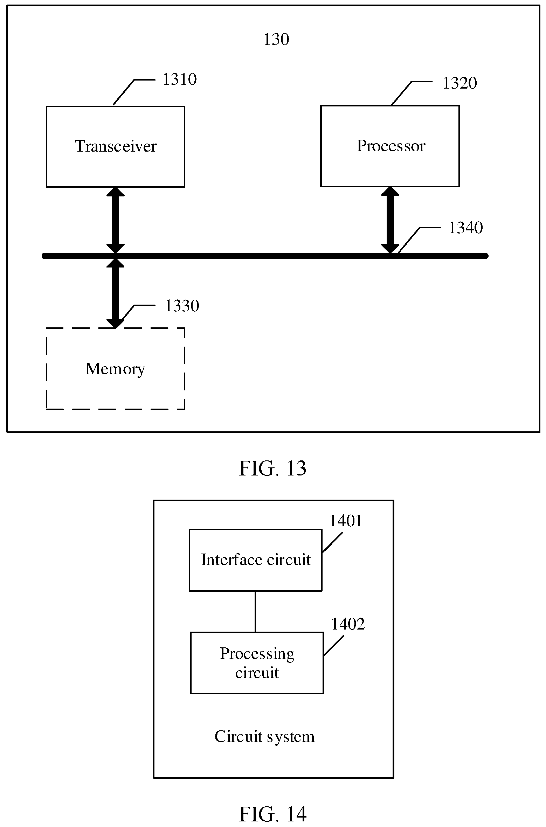

In some implementations, the communication apparatus shown in FIG. 12 may be a communication apparatus or a component that implements the foregoing functions in the communication apparatus in the foregoing method embodiments. In this case, the transceiver unit 1201 may be implemented by using a transceiver, and the processing unit 1202 may be implemented by using a processor. As shown in FIG. 13, a communication apparatus 130 includes one or more processors 1320 and a transceiver 1310. The processor and the transceiver may be configured to perform a function, an operation, or the like performed by the communication apparatus. Alternatively, the processor and the transceiver may alternatively be configured to perform a function, an operation, or the like performed by the transmit end or the receive end.

In this case, for functions, operations, or the like performed by the transceiver 1310 and/or the processor 1320, refer to FIG. 12. Details are not described herein again.

In implementations of the communication apparatus shown in FIG. 13, the transceiver may include a receiver and a transmitter, the receiver is configured to perform a receiving function (or operation), and the transmitter is configured to perform a transmitting function (or operation). The transceiver is configured to communicate with another device/apparatus by using a transmission medium. The processor 1320 receives and transmits data and/or signaling by using the transceiver 1310, and is configured to implement a corresponding method described in FIG. 7a, FIG. 8a, FIG. 9a, FIG. 10a, or FIG. 11 in the foregoing method embodiments.

Optionally, the communication apparatus 130 may further include one or more memories 1330, configured to store program instructions and/or data. The memory 1330 is coupled to the processor 1320. The coupling in this embodiment of this application may be an indirect coupling or a communication connection between apparatuses, units, or modules in an electrical form, a mechanical form, or another form, and is used for information exchange between the apparatuses, the units, or the modules. The processor 1320 may cooperate with the memory 1330. The processor 1320 may execute the program instructions stored in the memory 1330. Optionally, at least one of the one or more memories may be included in the processor.

A specific connection medium between the transceiver 1310, the processor 1320, and the memory 1330 is not limited in this embodiment of this application. In this embodiment of this application, in FIG. 13, the memory 1330, the processor 1320, and the transceiver 1310 are connected by using a bus 1340. The bus is represented by a bold line in FIG. 13. A connection manner between other components is merely a schematic description, and is not limited thereto. The bus may be classified into an address bus, a data bus, a control bus, and the like. For ease of representation, only one bold line is used for representation in FIG. 13, but this does not mean that there is only one bus or only one type of bus.

In embodiments of this application, the processor may be a general-purpose processor, a digital signal processor, an application-specific integrated circuit, a field programmable gate array or another programmable logic device, a discrete gate or transistor logic device, or a discrete hardware component, and may implement or perform the methods, steps, and logical block diagrams disclosed in embodiments of this application. The general-purpose processor may be a microprocessor, or may be any conventional processor or the like. The steps of the method disclosed with reference to embodiments of this application may be directly performed by a hardware processor, or may be performed by a combination of hardware and software modules in the processor, or the like.

It may be understood that the communication apparatus shown in this embodiment of this application may further have more components and the like than those shown in FIG. 13. This is not limited in this embodiment of this application.

It may be understood that the foregoing methods performed by the processor and the transceiver are merely examples. For specific steps performed by the processor and the transceiver, refer to the methods described above.

It may be understood that when the communication apparatus shown in FIG. 13 is the transmit end, for specific implementations of the transceiver and the processor, further refer to the foregoing embodiments. Details are not described herein again. For example, the processor may be configured to generate at least two block groups, and the transceiver may be configured to send the at least two block groups.

In some other implementations, the communication apparatus shown in FIG. 12 may be a circuit system (or a chip system or the like). In this case, the processing unit 1202 may be implemented by using a processing circuit, and the transceiver unit 1201 is implemented by using an interface circuit. As shown in FIG. 14, the circuit system may include a processing circuit 1402 and an interface circuit 1401. The processing circuit 1402 may be a chip, a logic circuit, an integrated circuit, a system on chip (system on chip, SoC), or the like, and the interface circuit 1401 may be a communication interface, an input/output interface, or the like. For example, the processing circuit and the interface circuit are coupled to each other. A specific manner of connecting the processing circuit and the interface circuit is not limited in this embodiment of this application.

The interface circuit may be configured to obtain data or output data. For example, the interface circuit may be configured to obtain at least two block groups. The processing circuit may be configured to: obtain a receiving quantity of first block groups between a first boundary block group and a second boundary block group; obtain a target quantity of first block groups between the first boundary block group and the second boundary block group; and determine a quantity of lost block groups based on the receiving quantity and the target quantity.

For another example, the processing circuit may be further configured to: determine a line bit error rate based on a quantity of lost block groups in a detection window; and initiate an alarm signal when the quantity of lost block groups in the detection window is greater than or equal to a first threshold; or eliminate the alarm signal when the quantity of lost block groups in the detection window is less than or equal to a second threshold.

It may be understood that for specific implementations of the interface circuit and the processing circuit, refer to the foregoing embodiments. Details are not described herein again.

It may be understood that when the communication apparatus shown in FIG. 14 is the transmit end, for specific implementations of the processing circuit and the interface circuit, further refer to the foregoing embodiments. Details are not described herein again. For example, the processing circuit may be configured to generate at least two block groups, and the interface circuit is configured to output the at least two block groups.

In the several embodiments provided in this application, it should be understood that the disclosed system, apparatus, and method may be implemented in other manners. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces, indirect couplings or communication connections between the apparatuses or units, or electrical connections, mechanical connections, or connections in other forms.

The units described as separate parts may or may not be physically separate, and parts displayed as units may or may not be physical units, may be located in one position, or may be distributed on a plurality of network units. Some or all of the units may be selected based on an actual requirement to implement the technical effects of the solutions provided in embodiments of this application.

In addition, function units in embodiments of this application may be integrated into one processing unit, each of the units may exist alone physically, or two or more units may be integrated into one unit. The integrated unit may be implemented in a form of hardware, or may be implemented in a form of a software functional unit.

When the integrated unit is implemented in the form of the software functional unit and sold or used as an independent product, the integrated unit may be stored in a computer-readable storage medium. Based on such an understanding, the technical solutions in this application essentially, or the part contributing to a conventional technology, or all or a part of the technical solutions may be implemented in a form of a software product. The computer software product is stored in a readable storage medium and includes several instructions for instructing a computer device (which may be a personal computer, a server, a network device, or the like) to perform all or a part of the steps of the methods in embodiments of this application. The foregoing readable storage medium includes any medium that can store program code, such as a USB flash drive, a removable hard disk, a read-only memory (read-only memory, ROM), a random access memory (random access memory, RAM), a magnetic disk, or an optical disc.

In addition, this application further provides a computer program, and the computer program is used to implement an operation and/or processing performed by a communication apparatus in the block group loss determining method provided in this application.

This application further provides a computer-readable storage medium. The computer-readable storage medium stores computer code. When the computer code is run on a computer, the computer performs an operation and/or processing performed by the communication apparatus in the block group loss determining method provided in this application.

This application further provides a computer program product. The computer program product includes computer code or a computer program. When the computer code or the computer program is run on a computer, an operation and/or processing performed by the communication apparatus in the block group loss determining method provided in this application are/is performed.

This application further provides a communication system. The communication system includes a transmit end and a receive end. For specific implementations of the transmit end and the receive end, refer to the foregoing embodiments. Details are not described herein again. For example, the transmit end may be configured to perform step 701 and step 702 shown in FIG. 7a, and the receive end may be configured to perform step 703 to step 705 shown in FIG. 7a. Optionally, the communication system may further include an intermediate node. For a specific implementation of the intermediate node, refer to steps performed by the receive end, or refer to FIG. 6b or the like. A method or a function performed by the intermediate node is not limited in this embodiment of this application.

The foregoing descriptions are merely specific implementations of this application, but are not intended to limit the protection scope of this application. Any variation or replacement readily figured out by a person skilled in the art within the technical scope disclosed in this application shall fall within the scope of this application. The protection scope of this application is defined by the appended claims.

**Claims**

1. A block group loss determining method, wherein the method comprises:

   receiving at least two block groups, wherein the at least two block groups comprise at least two boundary block groups, and the at least two boundary block groups comprise a first boundary block group and a second boundary block group;
   obtaining (703) a receiving quantity of first block groups between the first boundary block group and the second boundary block group, wherein the first block group is comprised in the at least two block groups;
   obtaining, from overhead information in the boundary block groups, a target quantity of first block groups between the first boundary block group and the second boundary block group; and
   determining (704) a quantity of lost block groups based on the receiving quantity and the target quantity, wherein each of the at least two block groups comprises at least three blocks, the blocks comprise a start block, a data block, and an end block, and the block group starts with the start block and ends with the end block, wherein the block is a P1 B/P2 B block, P1 represents a quantity of payload bits of the block, P2 represents a total quantity of bits in the block, and P2-P1 represents a quantity of synchronization header bits in the block.

2. The method according to claim 1, wherein a length of each of the at least two block groups is a preset length.

3. The method according to any one of claims 1 to 2, wherein each of the at least two block groups comprises cyclic redundancy check CRC information.

4. The method according to claim 3, wherein each of the at least two block groups is a group for which check on the CRC information succeeds.

5. The method according to any one of claims 1 to 4, wherein the boundary block group comprises first overhead information, and the first overhead information is used to identify the boundary block group.

6. The method according to claim 5, wherein the boundary block group further comprises fourth overhead information, and the fourth overhead information indicates the target quantity.

7. The method according to claim 6, wherein the fourth overhead information comprises a first quantity and/or a second quantity.

8. The method according to claim 7, wherein the target quantity is a sum of the first quantity and the second quantity, and the determining a quantity of lost block groups based on the receiving quantity and the target quantity comprises: when the receiving quantity is greater than the first quantity or the receiving quantity is greater than the second quantity, determining the quantity of lost block groups based on the receiving quantity and the target quantity.

9. The method according to any one of claims 1 to 4, wherein the first block group comprises second overhead information, and the second overhead information is used to identify the boundary block group.

10. A communication apparatus (130), wherein the apparatus (130) comprises:

a transceiver (1310), configured to receive at least two block groups, wherein the at least two block groups comprise at least two boundary block groups, and the at least two boundary block groups comprise a first boundary block group and a second boundary block group; and
a processor (1320), configured to receive a receiving quantity of first block groups between the first boundary block group and the second boundary block group, wherein the first block group is comprised in the at least two block groups;
the processor (1320) is further configured to obtain, from overhead information in the boundary block groups, a target quantity of first block groups between the first boundary block group and the second boundary block group;
the processor (1320) is further configured to determine a quantity of lost block groups based on the receiving quantity and the target quantity, wherein each of the at least two block groups comprises at least three blocks, the blocks comprise a start block, a data block, and an end block, and the block group starts with the start block and ends with the end block, wherein
the block is a P1 B/P2 B block, P1 represents a quantity of payload bits of the block, P2 represents a total quantity of bits in the block, and P2-P1 represents a quantity of synchronization header bits in the block.

11. The apparatus (130) according to claim 10, wherein a length of each of the at least two block groups is a preset length.

12. The apparatus (130) according to any one of claims 10 to 11, wherein each of the at least two block groups comprises cyclic redundancy check CRC information.

13. The apparatus (130) according to claim 12, wherein each of the at least two block groups is a group for which check on the CRC information succeeds.

**Patentansprüche**

1. Verfahren zur Bestimmung von Codeblockverlust, wobei das Verfahren Folgendes umfasst:

Empfangen von mindestens zwei Blockgruppen, wobei die mindestens zwei Blockgruppen mindestens zwei Grenzblockgruppen umfassen und die mindestens zwei Grenzblockgruppen eine erste Grenzblockgruppe und eine zweite Grenzblockgruppe umfassen;
Erlangen (703) einer Empfangsmenge von ersten Blockgruppen zwischen der ersten Grenzblockgruppe und der zweiten Grenzblockgruppe, wobei die erste Blockgruppe in den mindestens zwei Blockgruppen umfasst ist;
Erlangen einer Zielmenge von ersten Blockgruppen zwischen der ersten Grenzblockgruppe und der zweiten Grenzblockgruppe aus Overhead-Informationen in den Grenzblockgruppen; und
Bestimmen (704) einer Menge von verlorener Blockgruppen basierend auf der Empfangsmenge und der Zielmenge,
wobei jede der mindestens zwei Blockgruppen mindestens drei Blöcke umfasst, die Blöcke einen Startblock, einen Datenblock und einen Endblock umfassen und die Blockgruppe mit dem Startblock beginnt und mit dem Endblock endet, wobei
der Block ein P1 B/P2 B-Block ist, P1 eine Menge von Nutzlastbits des Blocks darstellt, P2 eine Gesamtmenge von Bits in dem Block darstellt und P2-P1 eine Menge von Synchronisationsheaderbits in dem Block darstellt.

**2.** Verfahren gemäß Anspruch 1, wobei die Länge jeder der mindestens zwei Blockgruppen eine voreingestellte Länge ist.

**3.** Verfahren gemäß einem der Ansprüche 1 bis 2, wobei jede der mindestens zwei Blockgruppen zyklische Redundanzprüfungs- (cyclic redundancy check, CRC)-Informationen umfasst.

**4.** Verfahren gemäß Anspruch 3, wobei jede der mindestens zwei Blockgruppen eine Gruppe ist, für die die Überprüfung der CRC-Informationen erfolgreich ist.

**5.** Verfahren gemäß einem der Ansprüche 1 bis 4, wobei die Grenzblockgruppe erste Overhead-Informationen umfasst und die ersten Overhead-Informationen verwendet werden, um die Grenzblockgruppe zu identifizieren.

**6.** Verfahren gemäß Anspruch 5, wobei die Grenzblockgruppe ferner vierte Overhead-Informationen umfasst und die vierten Overhead-Informationen die Zielmenge angeben.

**7.** Verfahren gemäß Anspruch 6, wobei die vierten Overhead-Informationen eine erste Menge und/oder eine zweite Menge umfassen.

**8.** Verfahren gemäß Anspruch 7, wobei die Zielmenge eine Summe aus der ersten Menge und der zweiten Menge ist und das Bestimmen einer Menge von verlorenen Blockgruppen basierend auf der empfangenen Menge und der Zielmenge Folgendes umfasst:
wenn die Empfangsmenge größer als die erste Menge ist oder die Empfangsmenge größer als die zweite Menge ist, Bestimmen der Menge von verlorenen Blockgruppen basierend auf der Empfangsmenge und der Zielmenge.

**9.** Verfahren gemäß einem der Ansprüche 1 bis 4, wobei die erste Blockgruppe zweite Overhead-Informationen umfasst und die zweiten Overhead-Informationen verwendet werden, um die Grenzblockgruppe zu identifizieren.

**10.** Kommunikationsvorrichtung (130), wobei die Vorrichtung (130) Folgendes umfasst:

einen Transceiver (1310), der dazu konfiguriert ist, mindestens zwei Blockgruppen zu empfangen, wobei die mindestens zwei Blockgruppen mindestens zwei Grenzblockgruppen umfassen und die mindestens zwei Grenzblockgruppen eine erste Grenzblockgruppe und eine zweite Grenzblockgruppe umfassen; und
einen Prozessor (1320), der dazu konfiguriert ist, eine Empfangsmenge von ersten Blockgruppen zwischen der ersten Grenzblockgruppe und der zweiten Grenzblockgruppe zu empfangen, wobei die erste Blockgruppe in den mindestens zwei Blockgruppen umfasst ist;
wobei der Prozessor (1320) ferner dazu konfiguriert ist, eine Zielmenge von ersten Blockgruppen zwischen der ersten Grenzblockgruppe und der zweiten Grenzblockgruppe aus Overhead-Informationen in den Grenzblockgruppen zu erlangen;
wobei der Prozessor (1320) ferner dazu konfiguriert ist, eine Menge von verlorenen Blockgruppen basierend auf der Empfangsmenge und der Zielmenge zu bestimmen, wobei jede der mindestens zwei Blockgruppen mindestens drei Blöcke umfasst, die Blöcke einen Startblock, einen Datenblock und einen Endblock umfassen und die Blockgruppe mit dem Startblock beginnt und mit dem Endblock endet, wobei
der Block ein P1 B/P2 B-Block ist, P1 eine Menge von Nutzlastbits des Blocks darstellt, P2 eine Gesamtmenge von Bits in dem Block darstellt und P2-P1 eine Menge von Synchronisationsheaderbits in dem Block darstellt.

**11.** Vorrichtung (130) gemäß Anspruch 10, wobei eine Länge jeder der mindestens zwei Blockgruppen eine voreingestellte Länge ist.

**12.** Vorrichtung (130) gemäß einem der Ansprüche 10 bis 11, wobei jede der mindestens zwei Blockgruppen zyklische Redundanzprüfungs-(CRC)-Informationen umfasst.

**13.** Vorrichtung (130) gemäß Anspruch 12, wobei jede der mindestens zwei Blockgruppen eine Gruppe ist, für die die Überprüfung der CRC-Informationen erfolgreich ist.

**Revendications**

**1.** Procédé destiné à déterminer la perte d'un groupe de blocs, dans lequel le procédé comprend :

la réception d'au moins deux groupes de blocs, dans lequel les au moins deux groupes de blocs comprennent au moins deux groupes de blocs limites, et les au moins deux groupes de blocs limites comprennent un premier groupe de blocs limites et un second groupe de blocs limites ;

l'obtention (703) d'une quantité de réception de premiers groupes de blocs entre le premier groupe de blocs limites et le second groupe de blocs limites, dans lequel le premier groupe de blocs est compris dans les au moins deux groupes de blocs ;

l'obtention, à partir des informations de surdébit dans les groupes de blocs limites, d'une quantité cible de premiers groupes de blocs entre le premier groupe de blocs limites et le second groupe de blocs limites ; et

la détermination (704) d'une quantité de groupes de blocs perdus sur la base de la quantité de réception et de la quantité cible,

dans lequel chacun des au moins deux groupes de blocs comprend au moins trois blocs, les blocs comprennent un bloc de départ, un bloc de données et un bloc de fin, et le groupe de blocs commence par le bloc de départ et se termine par le bloc de fin, dans lequel le bloc est un bloc P1 B/P2 B, P1 représente une quantité de bits de charge utile du bloc, P2 représente une quantité totale de bits dans le bloc et P2-P1 représente une quantité de bits d'entête de synchronisation dans le bloc.

2. Procédé selon la revendication 1, dans lequel une longueur de chacun des au moins deux groupes de blocs est une longueur prédéfinie.

3. Procédé selon l'une quelconque des revendications 1 et 2, dans lequel chacun des au moins deux groupes de blocs comprend des informations de contrôle de redondance cyclique CRC.

4. Procédé selon la revendication 3, dans lequel chacun des au moins deux groupes de blocs est un groupe pour lequel le contrôle des informations CRC réussit.

5. Procédé selon l'une quelconque des revendications 1 à 4, dans lequel le groupe de blocs limites comprend des premières informations de surdébit, et les premières informations de surdébit sont utilisées pour identifier le groupe de blocs limites.

6. Procédé selon la revendication 5, dans lequel le groupe de blocs limites comprend également des quatrièmes informations de surdébit, et les quatrièmes informations de surdébit indiquent la quantité cible.

7. Procédé selon la revendication 6, dans lequel les quatrièmes informations de surdébit comprennent une première quantité et/ou une seconde quantité.

8. Procédé selon la revendication 7, dans lequel la quantité cible est la somme de la première et de la seconde quantité, et la détermination de la quantité de groupes de blocs perdus sur la base de la quantité de réception et de la quantité cible comprend : lorsque la quantité de réception est supérieure à la première quantité ou que la quantité de réception est supérieure à la seconde quantité, la détermination de la quantité de groupes de blocs perdus sur la base de la quantité de réception et de la quantité cible.

9. Procédé selon l'une quelconque des revendications 1 à 4, dans lequel le premier groupe de blocs comprend des secondes informations de surdébit, et les secondes informations de surdébit sont utilisées pour identifier le groupe de blocs limites.

10. Appareil de communication (130), dans lequel l'appareil (130) comprend :

un émetteur-récepteur (1310) configuré pour recevoir au moins deux groupes de blocs, dans lequel les au moins deux groupes de blocs comprennent au moins deux groupes de blocs limites, et les au moins deux groupes de blocs limites comprennent un premier groupe de blocs limites et un second groupe de blocs limites ; et

un processeur (1320) configuré pour recevoir une quantité de réception de premiers groupes de blocs entre le premier groupe de blocs limites et le second groupe de blocs limites, dans lequel le premier groupe de blocs est compris dans les au moins deux groupes de blocs ;

le processeur (1320) est également configuré pour obtenir, à partir des informations de surdébit dans les groupes de blocs limites, une quantité cible de premiers groupes de blocs entre le premier groupe de blocs limites et le second groupe de blocs limites ;

le processeur (1320) est également configuré pour déterminer une quantité de groupes de blocs perdus sur la base de la quantité de réception et de la quantité cible, dans lequel chacun des au moins deux groupes de blocs comprend au moins trois blocs, les blocs comprennent un bloc de départ, un bloc de données et un bloc de fin, et le groupe de blocs commence par le bloc de départ et se termine par le bloc de fin, dans lequel

le bloc est un bloc P1 B/P2 B, P1 représente une quantité de bits de charge utile du bloc, P2 représente une quantité totale de bits dans le bloc et P2-P1 représente une quantité de bits d'en-tête de synchronisation dans le bloc.

11. Appareil (130) selon la revendication 10, dans lequel une longueur de chacun des au moins deux groupes de blocs est une longueur prédéfinie.

12. Appareil (130) selon l'une quelconque des revendications 10 et 11, dans lequel chacun des au moins deux groupes de blocs comprend des informations de contrôle de redondance cyclique CRC.

13. Appareil (130) selon la revendication 12, dans lequel chacun des au moins deux groupes de blocs est un groupe pour lequel le contrôle des informations CRC réussit.

FIG. 1

MTN path adaptation layer
(MTN path adaptation)

MTN path trail termination layer
(MTN path trail termination)

Path layer
(path layer)

MTN path connection layer
(MTN path connection)

...                         ...

MTN section adaptation layer
(MTN section adaptation)

MTN section adaptation layer
(MTN section adaptation)

MTN section trail
termination layer (MTN
section trail termination)

MTN section trail
termination layer (MTN
section trail termination)

Section layer
(section layer)

Adaptation layer
(adaptation)

Adaptation layer
(adaptation)

FIG. 2

: A trapezoid in the figure indicates that the module has at least an adaptation function, and may further include another function, the trapezoid indicates adaption in English, and for a specific definition, refer to ITU-T G.805/ITU-T G.800 and the like

: An inverted triangle in the figure indicates that the module has at least a termination function, and may further include another function, the inverted triangle indicates trail termination in English, and for a specific definition, refer to ITU-T G.805/ITU-T G.800 and the like

: An ellipse in the figure indicates that the module has a connection function, the ellipse indicates connection or subnetwork in English, and for a specific definition, refer to ITU-T G.805/ITU-T G.800 and the like

: A rectangle in the figure indicates that the module is a function module

FIG. 3

EP 4 160 956 B1

| 8 octets with T/RXC | | | | | | | | Sync | Block content | | | | | | | | | 2.5/5 10GE | 40GE 100GE | CPRI |
|---|---|---|---|---|---|---|---|---|---|---|---|---|---|---|---|---|---|---|---|---|
| D0 | D1 | D2 | D3 | D4 | D5 | D6 | D7 | 01 | D0 | D1 | D2 | D3 | D4 | D5 | D6 | D7 | | Valid | Valid | Valid |
| C0 | C1 | C2 | C3 | C4 | C5 | C6 | C7 | 10 | 0x1E | C0 | C1 | C2 | C3 | C4 | C5 | C6 | C7 | Valid | Valid | Invalid |
| C0 | C1 | C2 | C3 | O4 | D5 | D6 | D7 | 10 | 0x2D | C0 | C1 | C2 | C3 | O4 | D5 | D6 | D7 | Valid | Invalid | Invalid |
| C0 | C1 | C2 | C3 | S4 | D5 | D6 | D7 | 10 | 0x33 | C0 | C1 | C2 | C3 | | D5 | D6 | D7 | Valid | Invalid | Invalid |
| O0 | D1 | D2 | D3 | S4 | D5 | D6 | D7 | 10 | 0x66 | D1 | D2 | D3 | O0 | | D5 | D6 | D7 | Valid | Invalid | Invalid |
| O0 | D1 | D2 | D3 | O4 | D5 | D6 | D7 | 10 | 0x55 | D1 | D2 | D3 | O0 | O4 | D5 | D6 | D7 | Valid | Invalid | Invalid |
| S0 | D1 | D2 | D3 | D4 | D5 | D6 | D7 | 10 | 0x78 | D1 | D2 | D3 | D4 | D5 | D6 | D7 | | Valid | Valid | Valid |
| O0 | D1 | D2 | D3 | C4 | C5 | C6 | C7 | 10 | 0x4B | D1 | D2 | D3 | O0 | C4 | C5 | C6 | C7 | Valid | Valid | Invalid |
| T0 | C1 | C2 | C3 | C4 | C5 | C6 | C7 | 10 | 0x87 | | C1 | C2 | C3 | C4 | C5 | C6 | C7 | Valid | Valid | Invalid |
| D0 | T1 | C2 | C3 | C4 | C5 | C6 | C7 | 10 | 0x99 | D0 | | C2 | C3 | C4 | C5 | C6 | C7 | Valid | Valid | Invalid |
| D0 | D1 | T2 | C3 | C4 | C5 | C6 | C7 | 10 | 0xAA | D0 | D1 | | C3 | C4 | C5 | C6 | C7 | Valid | Valid | Invalid |
| D0 | D1 | D2 | T3 | C4 | C5 | C6 | C7 | 10 | 0xB4 | D0 | D1 | D2 | | C4 | C5 | C6 | C7 | Valid | Valid | Invalid |
| D0 | D1 | D2 | D3 | T4 | C5 | C6 | C7 | 10 | 0xCC | D0 | D1 | D2 | D3 | | C5 | C6 | C7 | Valid | Valid | Invalid |
| D0 | D1 | D2 | D3 | D4 | T5 | C6 | C7 | 10 | 0xD2 | D0 | D1 | D2 | D3 | D4 | | C6 | C7 | Valid | Valid | Invalid |
| D0 | D1 | D2 | D3 | D4 | D5 | T6 | C7 | 10 | 0xE1 | D0 | D1 | D2 | D3 | D4 | D5 | | C7 | Valid | Valid | Invalid |
| D0 | D1 | D2 | D3 | D4 | D5 | D6 | T7 | 10 | 0xFF | D0 | D1 | D2 | D3 | D4 | D5 | D6 | | Valid | Valid | Valid |
| | | | | | | | | 10 | Reserved | RRRRRRRRRRRRRRRRRRRRRRRRRRRRRRRRRRRRRRRRRRRRRRRRRRRRRRRRRRRRRRRRRR | | | | | | | | | | |

FIG. 4a

Fixed overhead location

Extended overhead location

| Block # | SH | 0–63 bit fields |
|---|---|---|
| 1 | 1 0 | 0x78 \| 0x55 \| 0x55 \| 0x55 \| 0x55 \| 0x55 \| 0x55 \| 0xD5 |
| 2 | 0 1 | Ch_ID [0:15] \| PT (0b0010) \| SubT \| R \| SEQ[0:5] \| Reserved / ESeq[0:9] \| OI \| 0 \| 0x4B \| Resv \| OAM_Type \| OAM_Value1 |
| 3 | 0 1 | OAM_Value2 \| 0xC \| 0x0 \| OAM_Value3 \| OAM_Value4 \| OAM_Seq \| OAM_CRC4 \| Payload (payload) |
| 4 | 0 1 | |
| 5 | 0 1 | Payload (payload) (22 x 64B/66B code block) |
| ... | 0 1 | |
| 26 | 1 0 | 0xCC \| CRC32 \| 0 0 0 \| C \| C \| C |
| 27 | 1 0 | 0x1E \| C \| C \| C \| C \| C \| C \| C \| C |

FIG. 4b

| S | | S |
|---|---|---|
| 0x55 | | 0x55 |
| 0x55 | | 0x55 |
| 0x55 | | 0x55 |
| 0x55 | | 0x55 |
| 0x55 | | 0x55 |
| 0x55 | | 0x55 |
| SFD/SMD | | SFD/SMD |
| Overhead information (&CRC) | | Ethernet MAC frame header |
| Payload (payload) | | Payload (payload) |
| ETH CRC32 | | ETH CRC32 |
| T (IPG) | | T (IPG) |
| I (IPG) | | I (IPG) |
| I (IPG) | | I (IPG) |
| I (IPG) | | I (IPG) |
| I (IPG) | | I (IPG) |
| I (IPG) | | I (IPG) |
| I (IPG) | | I (IPG) |
| I (IPG) | | I (IPG) |
| I (IPG) | | I (IPG) |
| Block group | | Ethernet MAC frame |

FIG. 4c

Second path that
includes N second
slots and is divided
into Y first slots

PHY 1

PHY 2

PHY 3

First path that
includes M
first slots

Bundle group that
is divided into X
second slots

FIG. 5a

Second path that
includes N second
slots and is
divided into Y
first slots

First path that
includes M
first slots

PHY 1

PHY 2

PHY 3

Bundle group that
is divided into X
second slots

FIG. 5b

Client signal flow
(Client)

MTN fg layer

MTN fg
Adaptation layer

MTN fg
termination layer

MTN fg connection layer

MTN path adaptation layer
(MTN path adaptation)

Path layer
(path layer)

MTN path trail termination layer
(MTN path trail termination)

MTN channel connection layer
(MTN path connection)

...                                    ...

MTN section adaptation layer
(MTN section adaptation)

MTN section adaptation layer
(MTN section adaptation)

Section layer
(section layer)

MTN section trail termination
layer (MTN section trail
termination)

MTN section trail termination
layer (MTN section trail
termination)

Adaptation layer
(adaptation)

Adaptation layer
(adaptation)

FIG. 6a

FIG. 6b

```
┌─────────────────────┐                          ┌─────────────────────┐
│    Transmit end     │                          │     Receive end     │
└─────────────────────┘                          └─────────────────────┘
          │                                                 │
          │                           701                   │
┌─────────────────────────────────┐  /                      │
│ Obtain at least two block groups │ │                       │
└─────────────────────────────────┘                         │
          │                                                 │
          │      Send the at least two block groups         │
          │      by using a first path, where the the       │
          │      at least two block groups include a        │
          │      first boundary block group and a    702    │
          │        second boundary block group       /      │
          │───────────────────────────────────────────────▶│
          │                                                 │
          │     ┌─────────────────────────────────────────────┐  703
          │     │  Obtain a receiving quantity of first block   │  /
          │     │ groups between the first boundary block group │ │
          │     │ and the second boundary block group, and      │
          │     │ obtain a target quantity of first block       │
          │     │ groups between the first boundary block       │
          │     │ group and the second boundary block group     │
          │     └─────────────────────────────────────────────┘
          │                                                 │
          │                                                    704
          │     ┌─────────────────────────────────────────────┐  /
          │     │ Determine a quantity of lost block groups     │
          │     │ based on the receiving quantity and the       │
          │     │ target quantity                               │
          │     └─────────────────────────────────────────────┘
          │                                                 │
          │     ┌ ─ ─ ─ ─ ─ ─ ─ ─ ─ ─ ─ ─ ─ ─ ─ ─ ─ ─ ─ ─ ┐   705
          │     │ Obtain the quantity of lost block groups in  │  /
          │       a detection window, and initiate an alarm    │
          │     │ signal when the quantity of lost block groups │
          │       in the detection window is greater than or  │
          │     │ equal to a first threshold                    │
          │     └ ─ ─ ─ ─ ─ ─ ─ ─ ─ ─ ─ ─ ─ ─ ─ ─ ─ ─ ─ ─ ┘
          │                                                 │
```

FIG. 7a

| 00 | 00 | 00 | 01 | 01 | 01 | 10 | 10 | 10 | 11 | 11 | 11 |
|----|----|----|----|----|----|----|----|----|----|----|----|

Third overhead
information changes

The third overhead
information
changes again

The third overhead
information
changes again

| 1 | 1 | 1 | 0 | 0 | 0 | 1 | 1 | 1 | 0 | 0 | 0 |
|---|---|---|---|---|---|---|---|---|---|---|---|

Third overhead
information changes

The third overhead
information
changes again

| 0 | 1 | 2 | 3 | 4 | 5 | 6 | 7 | 8 | 9 | 10 | 0 |
|---|---|---|---|---|---|---|---|---|---|----|---|

Third overhead
information
changes

The third overhead
information
changes again

FIG. 7b

Transmit end

Receive end

Encapsulate a client signal flow into a fixed-length block group, where the block group starts with an S block and ends with a T block, and the block group includes payload information, overhead information, and CRC information

801

802

At least two block groups

Perform CRC check on a received block group, and discard the block group when the CRC check fails, or reserve the block group when the CRC check succeeds

803

Identify whether a currently received block group is a boundary block group

804

No

Yes

Start a block group counter, and stop the block group counter when receiving a boundary block group such as a second boundary block group again, where a value of the block group counter is denoted as Q

805

Obtain a sending quantity (such as $P_k$ and $P_{k+1}$) included in overhead information of the second boundary block group

806

Determine a quantity of lost block groups based on a result of comparison between $P_k$ and Q or $P_k + P_{k+1}$ and Q

807

The receive end generates an alarm signal when the quantity of lost block groups in a detection window is greater than or equal to a first threshold

808

The block group counter increases by 1

809

FIG. 8a

FIG. 8b

EP 4 160 956 B1

Periodicity k  Periodicity k+1  Periodicity k+2

...  ...  ...

$Q_k$  $Q_{k+1}$  $Q_{k+2}$

$k^{th}$ boundary block group $(P_k, P_{k-1})$

$(k+1)^{th}$ boundary block group $(P_{k+1}, P_k)$

$(k+2)^{th}$ boundary block group $(P_{k+2}, P_{k+1})$

...  ...

Q

The $k^{th}$ boundary block group is lost

$(k+1)^{th}$ boundary block group $(P_{k+1}, P_k)$

First block group

Boundary block group

FIG. 8c

| Transmit end | Receive end |
|---|---|

**901**
Encapsulate a client signal flow into a fixed-length block group, where the block group starts with an S block and ends with a T block, and the block group includes payload information, overhead information, and CRC information

**902**
At least two block groups

**903**
Perform CRC check on a received block group, and discard the block group when the CRC check fails, or reserve the block group when the CRC check succeeds

**904**
Identify that an indicator bit is inverted, and start a block group counter if the indicator bit is inverted from 0 to 1, or stop the block group counter if it is identified that the indicator bit is inverted again, for example, the indicator bit is inverted from 1 to 0, where a value of the block group counter is denoted as Q

**905**
Compare M with Q, and trigger a block group loss counter to increase by (M–N) if M–Q>0

**906**
The receive end generates an alarm signal when a quantity of lost block groups in a detection window is greater than or equal to a first threshold

FIG. 9a

FIG. 9b

FIG. 9c

| Transmit end | | Receive end |
|---|---|---|

Encapsulate a client signal flow into a fixed-length block group, where the block group starts with an S block and ends with a T block, and the block group includes payload information, overhead information, and CRC information

1001

1002

At least two block groups

1003

Perform CRC check on a received block group, and discard the block group when the CRC check fails, or reserve the block group when the CRC check succeeds

The receive end compares block group sequence numbers of obtained two adjacent block groups, for example, a block group sequence number of a current block group is K, and a block group sequence number of a previous block group is P; if K–P>1, the receive end triggers a block group loss counter to increase by (K–P); if K–P=1 or (K–P)=(SEQmax–1), it indicates that no block group is lost and the block group loss counter is not triggered to perform counting; if K–P≤0, the receive end triggers the block group loss counter to increase by (SEQmax–(P–K)–1)

1004

The receive end generates an alarm signal when a quantity of lost block groups in a detection window is greater than or equal to a first threshold

1005

FIG. 10a

| 0 | 1 | 2 | ... | 15 | 0 | 1 | ... |

FIG. 10b

| 0 | 1 | 2 | 3 | ... | 15 | 0 | 1 | ... |

Boundary block group 1

Boundary block group 3

Boundary block group 4

Boundary block group 2

FIG. 10c

| 0 | 2 | One block group is lost

| 15 | 0 | No block group loss

| 8 | 7 | 13 block groups are lost

FIG. 10d

Transmit end

Receive end

Encapsulate a client signal flow into a fixed-length block group, where the block group starts with an S block and ends with a T block, and the block group includes payload information, overhead information, and CRC information

1101

At least two block groups

1102

The receive end performs CRC check on a received block group, and triggers a block group loss counter to increase by 1 when the CRC check fails

1103

Obtain a quantity of lost block groups based on the block group loss counter

1104

The receive end generates an alarm signal when the quantity of lost block groups in a detection window is greater than or equal to a first threshold

1105

FIG. 11

Transceiver unit

1201

Processing unit

1202

Communication apparatus

FIG. 12

130

1310

Transceiver

1320

Processor

1340

1330

Memory

FIG. 13

1401

Interface circuit

1402

Processing
circuit

Circuit system

FIG. 14

**REFERENCES CITED IN THE DESCRIPTION**

**Patent documents cited in the description**

- CN 202010569870
- US 2011188380 A1
- US 2020091932 A1

**Non-patent literature cited in the description**

- **HAIYAN ZHANG**. *Proposal for MPLS Packet Loss Measurement*, 14 April 2006
- MTN path layer BER monitoring. *ITU-T Draft*, 09 September 2019